# EUROPÄISCHE PATENTSCHRIFT

(11) **EP 3 459 103 B1**
(45) Veröffentlichungstag und Bekanntmachung des Hinweises auf die Patenterteilung: **29.07.2020**
(21) Anmeldenummer: 17722002.7
(22) Anmeldetag: 04.05.2017
(51) Int. Cl.: H01J 37/32, H02M 3/156, H02M 3/335, H02M 7/48, H05H 1/46

(54) **SCHALTUNGSANORDNUNG ZUR BEREITSTELLUNG VON HOCHFREQUENZENERGIE UND SYSTEM ZUR ERZEUGUNG EINER ELEKTRISCHEN ENTLADUNG**
CIRCUIT ASSEMBLY FOR PROVIDING HIGH-FREQUENCY ENERGY, AND SYSTEM FOR GENERATING AN ELECTRIC DISCHARGE
ENSEMBLE CIRCUIT POUR FOURNIR DE L'ÉNERGIE À HAUTE FRÉQUENCE ET SYSTÈME DE GÉNÉRATION DE DÉCHARGE ÉLECTRIQUE

(30) Priorität: 20.05.2016 DE 102016109343
(43) Veröffentlichungstag der Anmeldung: 27.03.2019
(73) Patentinhaber: Diener, Christof-Herbert, 72202 Nagold (DE)
(72) Erfinder: Diener, Christof-Herbert, 72202 Nagold (DE)
(74) Vertreter: Rüger Abel Patentanwälte PartGmbB
(86) Internationale Anmeldenummer: PCT/EP2017/060597
(87) Internationale Veröffentlichungsnummer: WO 2017/198469

(56) Entgegenhaltungen:
- EP-A1- 1 592 117
- EP-A1- 1 701 376
- DE-A1- 3 337 811
- DE-C2- 3 942 560

## Beschreibung

Die vorliegende Erfindung betrifft eine Schaltungsanordnung zur Bereitstellung von Hochfrequenzenergie zur Erzeugung einer elektrischen Entladung in einer Vakuumkammer sowie ein System zur Erzeugung einer elektrischen Entladung. Insbesondere betrifft die Erfindung eine Schaltungsanordnung zur Bereitstellung von Hochfrequenzenergie zur Plasmaerzeugung sowie ein Niederdruckplasmasystem.

Niederdruckplasmasysteme, die im hier relevanten Hochfrequenz(HF)-Bereich mit Anregungsfrequenzen für ein Plasma von mehr als 1 MHz arbeiten, werden z.B. zur Reinigung oder Aktivierung von Objekten aus Metall, Kunststoff, Glas und Keramik vor weiterer Bearbeitung, wie bspw. vor dem Sputtern, Lackieren, Kleben, Bedrucken, Löten und dgl., zum Ätzen oder Beschichten mittels Plasma, zur Plasmaerzeugung für Gas-Laser, z.B. CO₂-Laser, und für viele weitere Anwendungen verwendet.

John R. Hollahan und Alexis T. Bell: "Techniques and Applications of Plasma Chemistry", Verlag John Wiley & Sons, Inc. (1974), S. 393-399, beschreiben ein weit verbreitetes herkömmliches Niederdruckplasmasystem. Dieses enthält eine Vakuumkammer zur Aufnahme eines zu ionisierenden Mediums oder Prozessgases, eine Vakuumpumpe zur Erzeugung eines Vakuums in der Kammer, einen Hochfrequenzgenerator und Mittel zur Anlegung eines Hochfrequenzfeldes an die Vakuumkammer sowie ein Impedanzanpassungsnetzwerk. Gegebenenfalls können ferner Mittel zur Messung der der Vakuumkammer zugeführten HF-Leistung und/oder Mittel zur Druckmessung vorhanden sein.

Der Hochfrequenz(HF)-Generator dient dazu, die zur Plasmaerzeugung erforderliche HF-Leistung mit Werten zwischen bspw. 10 W und einigen kW bei der hohen Betriebsfrequenz zu liefern. Er muss Vorschriften in Bezug auf die nutzbaren Hochfrequenzbereiche, insbesondere die für die Industrie, Wissenschaft und Medizin (ISM) freigegebenen Frequenzen von 6,78 MHz, 13,56 MHz, 27,12 MHz oder 40,68 MHz erfüllen und in der Lage sein, mit einer Ausgangsimpedanz von 50 Ohm zu arbeiten. Im Allgemeinen enthält ein derartiger HF-Generator einen quarzgesteuerten HF-Oszillator, der meist mit einem LC-Schwingkreis oder als rückgekoppelter Oszillator bei einer Resonanzfrequenz arbeitet, die der gewünschten ISM-Frequenz entspricht, und als Quelle für das HF-Signal dient. Der HF-Generator weist ferner einen Verstärker, der das Signal von dem Oszillator verstärkt, und eine Endstufe auf, die eingerichtet ist, um eine gewünschte Ausgangsleistung und eine feste Ausgangsimpedanz des HF-Generators bereitzustellen. Zu diesem Zweck ist in der Regel eine Schaltung aus Spulen und Kondensatoren mit festen Induktivitäts- und Kapazitätswerten vorgesehen, die die Impedanz am Ausgang des Verstärkers in die gewünschte Ausgangsimpedanz des HF-Generators von z.B. 50 Ohm umsetzt. Das von dem HF-Generator erzeugte HF-Leistungssignal wird über Leitungen übertragen und an Elektroden der Vakuumkammer angelegt, um das Prozessgas darin anzuregen, eine elektrische Entladung herbeizuführen und so ein Plasma zu erzeugen.

Das Impedanzanpassungsnetzwerk, das auch als Matching-Einheit bezeichnet wird, ist zwischen den HF-Generator und die Vakuumkammer geschaltet und dient dazu, eine Anpassung zwischen der Impedanz des Generators und derjenigen der Last, insbesondere der Plasmakammer mit dem darin befindlichen Plasma, zu schaffen. Bei einer guten Impedanzanpassung kann Leistung von dem Generator bis zu der Entladung in der Vakuumkammer mit hoher Effizienz übertragen werden. Bei Fehlanpassung kommt es hingegen zu Reflexionen auf der Leitung zwischen dem HF-Generator und der Last, die Leistungsverluste nach sich ziehen. Impedanzanpassungsschaltungen basieren oft auf einer L-, T- oder Pi-Anordnung von Spulen und Kondensatoren, die geeignet zu bemessen sind.

In einem Niederdruckplasmasystem ist die Lastimpedanz von zahlreichen Faktoren abhängig und variabel. Bspw. hängt die Impedanz von der geometrischen Gestaltung der Vakuumkammer und der Anordnung der Elektroden der Vakuumkammer ab. Ferner beeinflussen die Art des verwendeten ionisierbaren Mediums bzw. Prozessgases, der Druck und die Temperatur in der Vakuumkammer und die zugeführte Leistung die Impedanz. Die Impedanz ändert sich sprunghaft beim Zünden und bleibt auch im Betrieb nicht konstant. Auch die Leitungsimpedanz der Leitung zwischen dem häufig entfernt befindlichen HF-Generator und der Vakuumkammer muss berücksichtigt werden. Typischerweise werden deshalb in Niederdruckplasmasystemen variable Impedanzanpassungsnetzwerke verwendet, deren Spulen und Kondensatoren variable Induktivitäts- und Kapazitätswerte aufweisen und einstellbar sind, um eine Lastimpedanz in die typische Ausgangsimpedanz von 50 Ohm eines HF-Generators zu transformieren. Eine geeignete und optimale Einstellung der Spulen und Kondensatoren zur Impedanzanpassung ist jedoch mühsam und zeitaufwendig, stark von der Erfahrung des Bedieners abhängig und kaum wiederholbar. Häufig wird die vom HF-Generator abgegebene Leistung mit der an der Vakuumkammer gemessenen Leistung verglichen, und die Spulen und Kondensatoren werden durch Probieren verstellt, um die Leistungen abzustimmen. Ohne richtige Abstimmung kann es zu Schwierigkeiten beim Zünden des Prozessgases in der Vakuumkammer kommen. In seltenen Fällen kann das Plasma nach dem Zünden aufgrund eines Impedanzabfalls wieder erlöschen. Eine optimale Impedanzanpassung kann selbst für erfahrenes Fachpersonal eine äußerst herausfordernde und aufwändige Prozedur darstellen.

Ein Vakuumplasmagenerator zur Behandlung von Werkstücken in einer Vakuumkammer mit einem Netzanschluss für den Anschluss an eine Spannungsversorgungsnetz, einem Netzgleichrichter, einem DC/DC-Wandler zur Erzeugung einer Zwischenkreisspannung, HF-Signalgeneratoren zur Erzeugung von HF-Signalen einer Grundfrequenz und unterschiedlicher Phasenlagen aus der Zwischenkreisspannung, einem 3dB-Kopppler, der die HF-Signale zu einem Ausgangssignal koppelt, und einem Impedanzanpassungsnetzwerk, das zwischen den 3dB-Kopppler und die Vakuumkammer geschaltet ist, ist auch aus der EP 1 701 376 A1 bekannt.

DE 39 42 560 C2 beschreibt einen Hochfrequenz-Generator für einen Plasma erzeugenden Verbraucher mit einer Gleichspannungs-Energiequelle und einem hochfrequent angesteuerten elektronischen Schalter, wobei der Plasma erzeugende Verbraucher direkt, ohne Zwischenschaltung eines Impedanzanpassungsnetzwerkes zwischen der Energiequelle und dem Schalter angeschlossen ist. Der Schalter wird durch ein HF-Rechteck-Steuersignal angesteuert, und die dadurch abwechselnd ein- und ausgeschaltete Ausgangsspannung der Energiequelle liegt direkt als Betriebsspannung an dem Plasma erzeugenden Verbraucher an. Um die Rechteckspannungs-Übertragung zu ermöglichen, wird bei diesem HF-Generator gezielt auf Induktivitäten und Kapazitäten zwischen der Energiequelle und den Anschlussklemmen des Generators verzichtet. Außerdem muss der MOSFET in der Lage sein, bei Versorgungsspannungen von einigen Hundert Volt hohe Ströme in der Größenordnung von 10 Ampere oder mehr in wenigen Nanosekunden zu schalten und geringe Eigeninduktivität aufweisen. Deshalb werden hier spezielle schnellschaltende Power-MOSFET-Transistoren eingesetzt, die interne Anschlüsse aufweisen, die über jeweils mehrere Bonddrähte mit externen Anschlüssen des Gehäuses des MOSFET-Transistors induktivitätsmindernd verbunden sind, wobei das Gehäuse jeweils zwei gateseitige Source-Anschlüsse und zwei drainseitige Source-Anschlüsse aufweist und wobei die Anschlüsse des Gehäuses jeweils eine sog. Stripline-Struktur aufweisen, d.h. nach außen flach und eng benachbart realisiert sind. Solche schnellschaltenden Power-MOSFET-Transistoren sind in dieser Schaltungstopologie zwingend erforderlich, bauen aber relativ groß, sind sehr kostspielig und erfordern eine entsprechend komplexe Schaltungsumgebung sowie besonders ausgeklügelte, schnelle und kostspielige Gate-Ansteuereinheiten (Gate-Treiber). Es besteht der Wunsch, auch für HF-Niederdruckplasmaanwendungen relativ handelsübliche und kostengünstige Schalter und zugehörige Ansteuereinheiten zu verwenden.

Aus DE 33 37 811 A1 ist ein Hochfrequenz-Generator bekannt, der eine Gleichspannungs-Energiequelle aufweist, deren Ausgang mit einem steuerbaren elektronischen Schalter verbunden ist. Die durch den Schalter ein- und ausgeschaltete Gleichspannung wird einer Energiezwischenspeicher- und Übertragungsvorrichtung in Form eines Transformators zugeführt, dessen Ausgang mit einem Niedertemperatur-Plasmagenerator verbunden ist. Der elektronische Schalter wird impulsartig von einer Steuerschaltung angesteuert, wobei an dem Ausgang des Transformators ein Hochspannungsausgangsimpuls zum Betreiben des Plasmagenerators entsteht. Mit diesem Generator lassen sich hochfrequente Hochspannungsimpulse, d.h. Impulse im MHz-Bereich, nicht erzeugen, da der Transformator bei derartigen Eingangsfrequenzen an seinem Ausgang infolge seines ohmschen und seines induktiven sowie kapazitiven Widerstandes Hochspannungsimpulse mit derartigen Frequenzen nicht mehr übertragen bzw. erzeugen kann. Außerdem ist hier der Schalter, ein MOSFET, zwischen die Energiequelle und den Transformator geschaltet, so dass das Source-Potential ein schwebendes Bezugspotential für den Gate-Anschluss und die daran angeschlossene Ansteuerschaltung bildet. Deshalb wird hier besonders kapazitätsarme Stromversorgung benötigt, um hohe Schaltverluste, EMV-Probleme und mögliche Funktionsstörungen zu vermeiden. Dies macht zusätzlich diesen Generator zur Verwendung für HF-Niederdruck-Plasmasysteme ungeeignet.

EP 1 592 117 A1 beschreibt einen Gleichspannungs-Hochfrequenz-Hochsetzstellerschaltkreis mit einem Versorgungsspannungseingang, einem Ausgang für erhöhte Spannung, einer Induktivität und einer Gleichrichterdiode, die zwischen dem Versorgungsspannungseingang und dem Ausgang für die erhöhte Spannung in Reihe geschaltet sind, und einem Lastkondensator, der zwischen der Gleichrichterdiode und Masse geschaltet ist. Der Ausgang für die erhöhte Spannung ist an dem Verbindungspunkt zwischen der Gleichrichterdiode und dem Lastkondensator herausgeführt. Ein Leistungsschalter ist zwischen Masse und einem Anschlussknoten zwischen der Induktivität und der Gleichrichterdiode geschaltet, und ein Streuerschaltkreis ist zur Steuerung des Leistungsschalters vorgesehen.

Ausgehend hiervon ist es eine Aufgabe der Erfindung, eine Schaltungsanordnung zur Bereitstellung von Hochfrequenzenergie im MHz-Bereich zur Erzeugung einer elektrischen Entladung in einer Vakuumkammer und ein System zur Erzeugung einer elektrischen Entladung zu schaffen, die die vorstehend beschriebenen Nachteile des Standes der Technik überwinden. Insbesondere ist es eine Aufgabe der Erfindung, eine solche Schaltungsanordnung und ein solches System zu schaffen, die eine geringe Anzahl einfacher, kostengünstiger Bauteile aufweisen, keine kostspieligen HF-POWER-MOSFET-Transistoren und zugehörige Ansteuereinheiten benötigen und ohne ein Impedanzanpassungsnetzwerk und Ausgangsspannungstransformation auskommen. Ferner sollte die Inbetriebnahme und Handhabung im Betrieb erleichtert und eine hohe Betriebseffizienz und -sicherheit ermöglicht sein.

Diese Aufgaben werden mit einer Schaltungsanordnung zur Bereitstellung von Hochfrequenzenergie mit den Merkmalen des Anspruchs 1 sowie durch ein System zur Erzeugung einer elektrischen Entladung mit den Merkmalen des Anspruchs 13 gelöst. Vorteilhafte Ausführungsformen sind Gegenstand der Unteransprüche.

In einem Aspekt der Erfindung ist eine Schaltungsanordnung zur Bereitstellung von Hochfrequenzenergie zur Erzeugung einer elektrischen Entladung in einer Vakuumkammer, insbesondere zur Plasmaerzeugung, geschaffen. Die Schaltungsanordnung weist eine Gleichspannungsversorgung auf, die eine Gleichspannung bereitstellt. Die Schaltungsanordnung weist ferner einen Hochsetzstellerschaltkreis auf, der eine Reihenschaltung aus einer Induktivität und einem ansteuerbaren Schalter enthält. Die Induktivität ist zwischen einem Pol der Gleichspannungsversorgung und einer ersten Elektrode des Schalters angeschlossen, wobei eine zweite Elektrode des Schalters gegen Masse geschaltet ist und wobei der Schalter ferner eine Steuerelektrode aufweist. Die Schaltungsanordnung weist ferner eine Ansteuereinheit auf, die eingerichtet ist, um den Schalter hochfrequent anzusteuern, um an der ersten Elektrode des Schalters Hochfrequenzenergie mit einer periodischen, impulsartigen Ausgangsspannung zu erzeugen, deren Spitzenbetrag größer ist als der Betrag der Gleichspannung der Gleichspannungsversorgung. Die Schaltungsanordnung weist ferner einen Ausgangsanschluss auf, der zur direkten Verbindung mit einer Elektrode der Vakuumkammer ohne Zwischenschaltung eines Impedanzanpassungsnetzwerkes und ohne Spannungstransformationsmittel bestimmt und unmittelbar mit der ersten Elektrode des Schalters verbunden ist, um die Hochfrequenzenergie mit der Ausgangsspannung direkt an die Vakuumkammer anzulegen.

Die Schaltungsanordnung gemäß der Erfindung stellt einen neuen HF-Generator bereit, der auf einer Topologie und Funktionsweise eines Hochsetzstellers beruht. Die Induktivität ist eingerichtet, um beim Schließen des Schalters stark aufmagnetisiert und beim Öffnen des Schalters wieder abmagnetisiert zu werden, um sich zu dem Ausgangsanschluss hin zu entladen. Damit kann der Hochsetzsteller einen hohen Strom und eine hohe Spannung, die sich beim Schließen des Schalters einstellt, an dem Ausgangsanschluss und einer unmittelbar daran angeschlossenen Vakuumkammer bereitstellen, die HF-Leistungen im kW-Bereich ermöglichen. Ein konventioneller HF-Generator kann vorteilhafterweise ebenso entfallen wie ein Impedanzanpassungsnetzwerk (eine Matching-Einheit), um die Lastimpedanz an die Ausgangsimpedanz des HF-Generators anzupassen. Vielmehr wird die durch den Hochsetzstellerschaltkreis erzeugte HF-Leistung ohne Impedanzanpassung und ohne eine weitere Transformation, direkt an den Ausgangsanschluss und die Vakuumkammer angelegt.

Die erfindungsgemäße Schaltungsanordnung ist frei von einem aus diskreten Bauelementen, wie Spulen und Kondensatoren, oder durch Rückkopplung gebildeten Resonanzkreis, der in herkömmlichen Systemen, bspw. Niederdruckplasmasystemen, vorgesehen ist, um eine HF-Wechselspannung zu erzeugen. Die erfindungsgemäße Schaltungsanordnung weist keinen derartigen Resonanzkreis auf. Die erfindungsgemäße Schaltungsanordnung ist ferner frei von Spulen und Kondensatoren, die zur Schaffung einer definierten Ausgangsimpedanz an dem Ausgangsanschluss dienen. In herkömmlichen Systemen sind hierzu zusätzliche Schaltkreise mit Spulen und Kondensatoren erforderlich, die die Ausgangsleistung eines konventionellen HF-Generators an die 50 Ohm-Ausgangsimpedanz für die Übertragung anpassen. Die erfindungsgemäße Schaltungsanordnung ist ferner frei von einer Matching-Einheit, wie sie herkömmlicherweise zwischen dem HF-Generator und der Last angeordnet ist. Durch die direkte Anlegung der Ausgangsleistung zur direkten Erzeugung von Plasma ohne Transformation haben Temperatur, Druck, Gasart, Korrosion, etc. kaum einen Einfluss auf eine Impedanzfehlanpassung. In dem Pfad der HF-Leistung kann zudem ein sehr guter Wirkungsgrad erzielt werden. Zusätzlich werden durch Einsparung der Matching-Einheit sowie von Zuleitungen Verluste reduziert. Mit der Erfindung können relativ hohe Wirkungsgrade von ca. 70 bis 85% erreicht werden. Durch den vereinfachten Aufbau können auch Rohstoffe und Bauteile, vor allem teure variable Bauteile, und damit verbundene Kosten eingespart werden. Aufwendige Einstellarbeiten durch spezialisierte Bediener sind nicht erforderlich. Es kann eine hohe Zuverlässigkeit und gegebenenfalls Redundanz im Betrieb erreicht werden.

Die erfindungsgemäße Schaltungsanordnung ist für vielfältige Anwendungen geeignet. In einer bevorzugten Anwendung ist sie für den Betrieb in Niederdruckplasmasystemen eingerichtet, die eine Plasmakammer mit einem Betriebsdruck aufweisen, der kleiner ist als der Atmosphärendruck, vorzugsweise etwa 0,01 mbar bis 200 mbar, mehr bevorzugt 0,01 mbar bis 5 mbar, besonders bevorzugt etwa 0,05 mbar bis 2 mbar beträgt. Derartige Niederdruckplasmasysteme sind zur Reinigung oder Aktivierung von Werkstücken vor Weiterverarbeitung, bspw. durch Kleben, Bedrucken, Löten und dgl., oder zur Beschichtung oder Ätzung von Materialien bestens geeignet. Die Schaltungsanordnung könnte auch in Verbindung mit Gas-Lasern verwendet werden, um Hochfrequenzenergie in diese einzukoppeln.

In der bevorzugten Anwendung für Niederdruckplasmasysteme kann die Gleichspannung vorzugsweise im Bereich von 0 bis 400 V liegen. Die Ausgangsspannung, die durch den Hochsetzstellerschaltkreis erzeugt wird, kann mehr als 350 V betragen oder sogar im Bereich von 400 V bis 900 V, gegebenenfalls bis 1500 V oder darüber liegen. Die Ansteuerfrequenz und die Frequenz der Ausgangsspannung entsprechen einer der ISM-Frequenzen f_{ISM} von 6,78 MHz, 13,56 MHz, 27,12 MHz oder 40,68 MHz. Vorzugsweise beträgt sie 13,56 MHz.

Die Schaltungsanordnung kommt ohne einen LC-Oszillator und ohne einen rückgekoppelten Oszillator aus. Um den periodischen Betrieb zu unterstützen und den quasiresonanten Hochsetzsteller zu schaffen, kann die Induktivität vorzugsweise speziell derart gewählt sein, dass sie in Kombination mit dem kapazitiven Anteil der Impedanz der Vakuumkammer eine Resonanzfrequenz eines Quasi-Schwingkreises aus der Induktivität und dem kapazitiven Impedanzanteil der Vakuumkammer ergibt, die im Bereich von 0,5 x f_{ISM} bis 1,5 x f_{ISM}, vorzugsweise im Bereich von 0,9 x f_{ISM} bis 1,4 x f_{ISM}, liegt, wobei f_{ISM} die gewünschte Ansteuerfrequenz bzw. die Frequenz der Ausgangsspannung, bspw. 13,56 MHz, ist. Die Impedanz der Vakuumkammer ist unter anderem durch die Konstruktion und geometrische Anordnung der Vakuumkammer, deren Elektroden, die parasitären Kapazitäten des Schalters und einer die Schaltungsanordnung tragenden Platine gegen Masse bestimmt und kann berechnet oder empirisch ermittelt werden. Durch die Berücksichtigung der jeweils gegebenen Kapazität der Elektroden der Vakuumkammer für die Auslegung der Induktivität werden diese Elektroden faktisch zu einem integralen Teil der Schaltungsanordnung. Bei einer derartigen Auslegung der Induktivität können relativ hohe Ausgangsspannungsimpulse periodisch an der ersten Elektrode des Schalters des Hochsetzstellers erzeugt und gemeinsam mit einem periodischen Wechselstrom als HF-Energie direkt in die Vakuumkammer eingespeist werden. Durch zeitlich geeignete Ansteuerung kann der Schalter im Nulldurchgang der Spannung, verlustfrei eingeschaltet werden, wodurch Leistungsverluste reduziert werden.

Als ansteuerbarer Schalter für die Schaltungsanordnung werden vorzugsweise Leistungshalbleiterschalter, insbesondere Bipolartransistoren, oder auch Elektronenröhren verwendet. Bevorzugterweise werden kostengünstige konventionelle Leistungs-MOSFETs eingesetzt. Schnellschaltende eigeninduktivitätsarme Hochfrequenz-Power-MOSFET-Transistoren mit zugehörigen aufwändigen Gehäusen, wie sie bspw. eingangs im Zusammenhang mit der DE 39 42 560 C2 beschrieben sind, werden hier nicht benötigt.

Der ansteuerbare Schalter kann insbesondere ein Halbleitertransistor mit einer Eingangskapazität sein, die kleiner als 5 nF, vorzugsweise kleiner als 1 nF ist. Dann kann die Eingangskapazität entsprechend der Betriebsfrequenz hinreichend schnell umgeladen werden. Ferner weist der ansteuerbare Schalter vorzugsweise eine Sperrspannung auf, die größer ist als 500 V, vorzugsweise größer als 900 V. Dies ermöglicht es, die hohen HF-Wechselspannungen mit Spitzenwerten oberhalb von 400 Vₚₑₐₖ, gegebenenfalls bis 900 Vₚₑₐₖ, zu erzeugen, ohne dass Gefahr einer Beschädigung des Schalters besteht. Ferner weist der ansteuerbare Schalter vorzugsweise Anstiegszeiten und Fallzeiten auf, die kleiner als 15 ns sind, um den Hochfrequenzanforderungen zu genügen. Siliziumkarbid-Leistungs-MOSFETs können diese Anforderungen vorteilhafterweise erfüllen und werden bevorzugt eingesetzt. Jedoch können z.B. auch Galliumnitrid-Leistungs-MOSFETs oder andere derzeit bekannte oder künftig entwickelte Halbleiterschalter oder andere ansteuerbare Schalter, die diese Anforderungen, insbesondere hinsichtlich der hohen Sperrspannungen, erfüllen, eingesetzt werden.

Aufgrund der niedrigen Eingangskapazität des Schalters, die zur Umschaltung umgeladen werden muss, kann die Ansteuereinheit für den Schalter, z.B. ein Gate-Treiber für einen MOSFET-Schalter, vorteilhafterweise eingerichtet sein, um den Schalter mit einem relativ geringen Ansteuerstrom bzw. Treiberstrom von weniger als 10 A, vorzugsweise sogar weniger als 5 A, besonders bevorzugt sogar weniger als 2 A anzusteuern. Es können also kleine, kostengünstige Ansteuereinheiten oder Treiber verwendet werden, die als integrierte Schaltungen mit einem relativ einfach gestalteten, platzsparenden Gehäuse kommerziell erhältlich sind. Es können z.B. preisgünstige TO-247-Halbleitergehäuse verwendet werden.

Zur Steuerung des Betriebs der Schaltungsanordnung ist vorzugsweise eine Steuereinrichtung vorgesehen. Diese kann als ein Mikroprozessor oder dgl. auf einer mit dem Hochsetzstellerschaltkreis und der Ansteuereinheit gemeinsamen Platine oder auf einer gesonderten Platine angeordnet sein. Die Steuereinrichtung könnte auch Teil eines Computers, einer Workstation oder dgl. sein, der bzw. die mit der Schaltungsanordnung in Kommunikationsverbindung steht.

In einer bevorzugten Ausführungsform ist die Steuereinrichtung vorzugsweise dazu eingerichtet, einen Normalbetriebsmodus und einen Zündbetriebsmodus zu bewirken, der sich von dem Normalbetriebsmodus unterscheidet. Insbesondere kann die Schaltungsanordnung eingerichtet sein, um in dem Zündbetriebsmodus eine Ausgangsspannung zu erzeugen, die gegenüber dem Normalbetriebsmodus um ein Maß, vorzugsweise um wenigstens 10% des Mittelwertes der Ausgangsspannung im Normalbetriebsmodus, erhöht ist. Die erhöhte Ausgangsspannung trägt der höheren Impedanz des zu ionisierenden Mediums vor dem Zünden Rechnung und hilft, durch erhöhten HF-Leistungseintrag, ein sicheres Zünden zu ermöglichen. Im Normalbetrieb kann dann die eingekoppelte HF-Leistung reduziert werden. Die Erhöhung der Ausgangsspannung für den Zündbetriebsmodus kann durch eine Erhöhung der Eingangsspannung, von z.B. 100 V im Normalbetrieb auf 150 V im Zündbetriebsmodus erreicht werden.

In einer vorteilhaften Implementierung ist die Steuereinrichtung dazu eingerichtet, den Zündbetriebsmodus periodisch mit einer Frequenz, die deutlich kleiner ist als die Betriebshochfrequenz, im laufenden Betrieb zu bewirken. Bspw. kann diese Frequenz etwa 100 Hz betragen. Somit ist keine Einstellung oder Initiierung des Zündbetriebsmodus, z.B. durch einen Bediener, erforderlich. Vielmehr ist der Zündbetriebsmodus Teil des kontinuierlichen Normalbetriebsmodus. Auch beim versehentlichen Erlöschen eines Plasmas kann dieses unmittelbar sofort wieder gezündet werden.

In bevorzugten Ausführungsformen weist die Schaltungsanordnung zwei oder vorzugsweise mehrere an eine gemeinsame Gleichspannungsversorgung angeschlossene Hochsetzstellerschaltkreise mit zugehöriger Induktivität, zugehörigem ansteuerbaren Schalter und mit zugehörigen individuellen Ausgangsanschlüssen zur Ankopplung von Hochfrequenzenergie an separate Elektroden einer Vakuumkammer sowie eine Anzahl den Schaltern zugeordneter Ansteuereinheiten auf. Eine Ansteuereinheit kann jeweils einem oder auch zwei Hochsetzstellerschaltkreisen zugeordnet sein, wenn sie dies bewältigen kann. Die Anzahl der Bauteile und der Raumbedarf für die Schaltungsanordnung können dadurch weiter reduziert werden.

Die Schaltungsanordnung kann eine Taktgebereinheit aufweisen, die ein Zeittaktsignal an alle vorhandenen Ansteuereinheiten derart liefert, dass diese weitgehend synchron betrieben werden. Insbesondere kann vorgesehen sein, dass die Ansteuereinheiten innerhalb einer Phasenabweichung von maximal 10%, vorzugsweise weniger als 2%, synchron betrieben werden. Wenn die Hochsetzstellerschaltkreise verschiedene Elektroden der Vakuumkammer versorgen, die über die Vakuumkammer hinweg verteilt angeordnet sind, kann somit eine weitgehend synchrone, phasengleiche Anregung erzielt und ein homogenes Plasma in der gesamten Plasmakammer erhalten werden.

Die erfindungsgemäße Schaltungsanordnung zeichnet sich durch hohe Sicherheit und Zuverlässigkeit aus. Sie ist inhärent kurschlusssicher, da der Schalter des Hochsetzstellerschaltkreises bei einem Kurzschluss in der Vakuumkammer nicht im Strompfad liegt und nur eine geringe Zwischenkreiskapazität benötigt wird. Außerdem arbeiten die verteilten Leistungsbauelemente auf relativ niedrigem Temperaturniveau. Vorzugsweise weist die Schaltungsanordnung ferner eine allen Schaltern der Hochsetzstellerschaltkreise vorgelagerte, gemeinsame Schutzeinrichtung zur Überstromabschaltung auf, die bei einer festlegbaren Stromaufnahme der Gesamtschaltung die Stromversorgung dauerhaft oder für einen definierten Zeitraum unterbricht. Damit können Bauelemente der Schaltungsanordnung und die Platine insgesamt geschützt werden. Dies kann z.B. bei unverhofften Kurzschlüssen in der Kammer, die bspw. durch umfallende behandelte Objekte verursacht werden, äußerst wichtig sein.

Die Schaltungsanordnung kann zusätzlich oder alternativ eine Überspannungsschutzeinrichtung aufweisen, die dazu eingerichtet ist, eine gegebenenfalls auftretende Überspannung abzubauen. Vorzugsweise kann eine Entladungsstrecke, z.B. sog. Schaltfunkenstrecke, am Ausgang eines jeden Schalters des Hochsetzstellerschaltkreises vorgesehen sein, die im Falle einer Überspannung selbsttätig zündet oder gezündet wird.

Zu den Schutzeinrichtungen für die Schaltungsanordnung kann ferner optional eine Schutzeinrichtung gegen Übertemperatur gehören. Bei einer Übertemperatur kann, wie in anderen Fällen, die Schaltungsanordnung kurzzeitig oder dauerhaft abgeschaltet und/oder ein Alarm für eine Bedienperson ausgegeben werden.

Gemäß einem weiteren Aspekt der Erfindung ist ein System zur Erzeugung einer elektrischen Entladung, insbesondere ein Niederdruckplasmasystem, geschaffen. Das System weist eine Vakuumkammer, insbesondere Plasmakammer, zur Aufnahme eines ionisierbaren Mediums auf, wobei die Vakuumkammer eine Anzahl Elektroden enthält, um Hochfrequenzenergie induktiv, kapazitiv oder direkt in das ionisierbare Medium einzukoppeln, um das Medium zu ionisieren. Ferner weist das System eine Schaltungsanordnung zur Bereitstellung von Hochfrequenzenergie, wie vorstehend beschrieben, auf. Jeder Ausgangsanschluss der Schaltungsanordnung ist direkt, ohne Zwischenschaltung eines Impedanzanpassungsnetzwerks mit einer Elektrode der Vakuumkammer verbunden.

Somit kann ein System, insbesondere Niederdruckplasmasystem, geschaffen werden, das von der vorteilhaften Konstruktion der erfindungsgemäßen Schaltungsanordnung profitiert, deren Vorteile auch dem gesamten System zu Gute kommen. Das resultierende System ist einfach aufgebaut, kompakt und kostengünstig. Es kommt ohne einen konventionellen HF-Generator, ohne eine zwischen diesem und der Vakuumkammer angeordnete Impedanzanpassungseinheit, ohne dazwischengeschaltete Mittel zur Spannungstransformation sowie ohne kostspielige HF-Power-MOSFET-Transistoren und zugehörige HF-Treiber aus. Insbesondere kann das System zuverlässig eingeschaltet und betrieben, ein Plasma sicher gezündet und stabil aufrechterhalten werden. Eine Fehlanpassung durch Temperatur, Druck, Gasart, Fehlbedienung, Korrosion von Kontakten, Elektroden und Leitungen, wie bei herkömmlichen Systemen, treten hier nicht auf. Durch sehr kleine Abmessungen der Generatorsegmente und kurze Kommutierungswege können EMV-Emissionen gering gehalten werden. Außerdem werden Leitungsverluste reduziert, so dass ein hoher Wirkungsgrad des gesamten Systems erzielt werden kann. Durch den Wegfall der Impedanzanpassungseinheit, der Zuleitungen und des konventionellen Plasmagenerators können teure variable Bauteile, Rohstoffe und Einstellarbeiten, die von Spezialisten durchgeführt werden müssen, vermieden werden.

In bevorzugten Ausführungsformen des erfindungsgemäßen Systems ist die Schaltungsanordnung auf einer oder mehreren Platinen implementiert, die in unmittelbarer Nähe der Vakuumkammer angeordnet und vorzugsweise mit dieser in einem gemeinsamen Gehäuse untergebracht ist bzw. sind. Besonders bevorzugt kann die wenigstens eine Platine in direktem Kontakt mit der Kammer bzw. deren Elektroden stehen. Bspw. können Ausgangsanschlüsse der Platine mit Elektrodenanschlüssen der Vakuumkammer in direkter Einsteck- oder Schraubverbindung stehen. Dann sind keine oder nur relativ kurze Verbindungsleitungen zwischen der Platine und den Elektrodenanschlüssen der Vakuumkammer erforderlich. Jedenfalls kann die Leitungsimpedanz vernachlässigt werden. Diese kann keine wesentliche Fehlanpassung zwischen der Ausgangsimpedanz des Hochsetzstellerschaltkreises und der Vakuumkammer und keine damit verbundenen Reflexionen und Leistungsverluste bewirken.

Vorteilhafterweise kann die wenigstens eine Platine in derartiger räumlicher Nähe zu der Vakuumkammer angeordnet sein, dass die elektrische Verbindungsstrecke zwischen der ersten Elektrode eines jeden ansteuerbaren Schalters der Schaltungsanordnung und der zugehörigen Elektrode der Vakuumkammer kürzer als 100 cm, vorzugsweise kürzer als 20 cm, besonders bevorzugt kürzer als 12 cm, ist.

Zusätzlich oder alternativ kann die Induktivität der Verbindungsstrecke zwischen der ersten Elektrode eines jeden ansteuerbaren Schalters der Schaltungsanordnung und der zugehörigen Elektrode der Vakuumkammer weniger als 10 µH, vorzugsweise weniger als 1 µH, besonders bevorzugt weniger als 250 nH betragen. Eine derartige kurze Verbindungsstrecke bzw. geringe Induktivität der Verbindungsstrecke vermeidet eine Impedanzfehlanpassung oder Wellenreflexionen auf der Verbindungsstrecke mit den zugehörigen Leistungsverlusten.

In bestimmten Ausführungsformen der Erfindung kann die Vakuumkammer eine Glaskammer sein, die eine Kammerwand aus Glas, vorzugsweise Quarzglas oder Borosilikatglas, aufweist, die den Innenraum der Vakuumkammer umgibt. Die Elektroden der Vakuumkammer können z.B. in Form von Spiralspulen oder Kondensatorelektroden an der Außenseite der Kammerwand angeordnet sein. Vorzugsweise sind mehrere derartiger Elektroden äquidistant, gleichmäßig verteilt entlang einer Längsrichtung der Vakuumkammer vorgesehen, um eine homogene Energieeinkopplung über die Vakuumkammer hinweg zu erzielen und dadurch ein homogenes Plasma zu erhalten. Jeder Elektrode der Vakuumkammer ist ein zugehöriger Hochsetzstellerschaltkreis der Schaltungsanordnung zugeordnet.

In einer besonderen Ausführungsformen kann jeder Schalter der Schaltungsanordnung mit zugehöriger Elektrode wärmeleitend verbunden sein. Bspw. kann der Schalter direkt an der zugehörigen spiralförmigen Spule oder flächigen Kapazitätselektrode, gegebenenfalls mit einer elektrischen Isolierlage dazwischen angebracht oder indirekt mit dieser verbunden sein. Jedenfalls dient die Elektrode der Vakuumkammer dann gleichzeitig auch als ein Kühlkörper für den Schalter, insbesondere Leistungshalbleiterschalter, um die im Betrieb auftretende Wärme wirkungsvoll von diesem abzuleiten.

In anderen Ausführungsformen kann die Vakuumkammer eine Metallkammer sein, die eine Kammerwand aus Metall, vorzugsweise Aluminium oder Edelstahl, aufweist, die den Innenraum der Vakuumkammer umgibt. Die Elektroden der Vakuumkammer ragen dann in den Innenraum der Vakuumkammer hinein, wobei vorzugsweise ebenfalls mehrere derartige Elektroden vorgesehen sind, die äquidistant, gleichmäßig verteilt entlang einer Längsrichtung der Vakuumkammer vorgesehen sind. Jeder Elektrode ist ein zugehöriger Hochsetzstellerschaltkreis der Schaltungsanordnung zugeordnet. Zur Unterdrückung eines Gleichspannungsanteils der Hochfrequenz-Ausgangsspannung ist zwischen der Elektrode der Vakuumkammer und dem zugehörigen Schalter der Schaltungsanordnung ein Kondensator mit einem Kapazitätswert von vorzugsweise 2 bis 50 nF vorgesehen.

In bevorzugten Ausführungsformen, die eine Vakuumkammer aus Metall verwenden, kann jeder Schalter der Schaltungsanordnung mit der metallenen Kammerwand wärmeleitend verbunden sein. Bspw. können die Schalter über wärmeleitende elektrische Isolierschichten oder -scheiben direkt an der metallenen Kammerwand angebracht oder über Wärmeleitungen mit dieser indirekt verbunden sein, um Wärme im Betrieb an die Kammer abzuführen.

Das System kann auch mehrere erfindungsgemäße Schaltungsanordnungen mit jeweils mehreren Hochsetzstellerschaltkreisen, Ansteuereinheiten und Ausgangsanschlüssen enthalten. Die Schaltungsanordnungen können auf eine Anzahl Platinen verteilt sein, die parallel zueinander geschaltet, vorzugsweise jeweils von einer eigenen Gleichspannungsversorgung gespeist sind. Alle Platinen und Schalter können von einem gemeinsamen Taktgeber mit einem gemeinsamen Zeittaktsignal versorgt werden. Die Leitungsverbindungen können derart geführt sein, dass eine möglichst synchrone Zeittaktzuführung zu allen Ansteuereinheiten erhalten wird. Insbesondere können in die Leitungsverbindungen geeignete Zeitverzögerungsglieder aufgenommen sein, die die Synchronität der Zeittaktzuführung unterstützen. Vorzugsweise ist jede Platine für sich gegen Überspannung und/oder Überstrom und/oder Übertemperatur geschützt.

Im Übrigen entsprechen Weiterbildungen des erfindungsgemäßen Systems den vorstehend erwähnten Ausführungsformen der erfindungsgemäßen Schaltungsanordnung. Um Wiederholungen zu vermeiden, wird auf die vorstehenden Erläuterungen zu den Ausführungsformen der Schaltungsanordnung und deren Vorteile verwiesen, die hier gleichermaßen für das gesamte System gelten.

In einer vorteilhaften Ausführungsform des Systems sind zwei oder mehrere Ausgangsanschlüsse der Schaltungsanordnung, z.B. über ein Blech, miteinander elektrisch leitend verbunden, um eine einzige gemeinsame aktive Elektrode für die Plasmakammer zu bilden. Dadurch kann mittels der Schaltungsanordnung eine deutlich höhere, kumulierte HF-Leistung an die Vakuumkammer angelegt werden, die auch 10 kW oder mehr betragen könnte. Außerdem kann in einem räumlich ausgedehnten Bereich der Vakuumkammer eine homogenere HF-Leistung eingespeist und somit ein homogeneres Plasma erzeugt werden.

Weitere vorteilhafte Einzelheiten von Ausführungsformen der Erfindung ergeben sich aus den Unteransprüchen, der Zeichnung sowie der zugehörigen Beschreibung. Die Erfindung ist nachstehend anhand einer Zeichnung näher beschrieben, die beispielhafte, keinesfalls beschränkende Ausführungsform der Erfindung zeigt, wobei gleiche Bezugszeichen in allen Figuren verwendet werden, um gleiche Elemente zu bezeichnen. Es zeigen:
Fig. 1 ein Blockdiagramm eines Niederdruckplasmasystems, in dem die Erfindung verwendet werden kann, in stark schematisierter Prinzipdarstellung;
Fig. 2 eine beispielhafte Schaltungsanordnung zur Bereitstellung von Hochfrequenzenergie bspw. für das System nach Fig. 1 gemäß einer Ausführungsform der Erfindung, in stark vereinfachter Darstellung;
Fig. 3 eine modifizierte Schaltungsanordnung zur Bereitstellung von Hochfrequenzenergie bspw. für das System nach Fig. 1 gemäß einer weiteren Ausführungsform der Erfindung, in stark vereinfachter Darstellung;
Fig. 4 eine weiter modifizierte Schaltungsanordnung zur Bereitstellung von Hochfrequenzenergie bspw. für das System nach Fig. 1 gemäß einer noch weiteren Ausführungsform der Erfindung, in stark vereinfachter Darstellung;
Fig. 5 zeitliche Verläufe von Spannungen und Strömen beim Betrieb der Schaltungsanordnung der Ausführungsform nach Fig. 2 in dem System nach Fig. 1, in vereinfachter Darstellung;
Fig. 6 den zeitlichen Verlauf der Versorgungsspannung für die Schaltungsanordnung der Ausführungsform nach Fig. 2 zur Unterstützung eines Zündbetriebs, in stark vereinfachter Darstellung;
Figuren 7a-7c stark vereinfachte Darstellungen unterschiedlicher Konfigurationen von Niederdruckplasmasystemen mit mehreren Elektroden an einer Plasmakammer und erfindungsgemäßer Schaltungsanordnung, gemäß einer Ausführungsform der Erfindung;
Fig. 8 ein Blockdiagramm der Schaltungsanordnung zur Bereitstellung von Hochfrequenzenergie für eines der Systeme gemäß den Figuren 7a-7c, in stark vereinfachter Prinzipdarstellung; und
Fig. 9 ein modifiziertes Niederdruckplasmasystem mit einer Schaltungsanordnung zur Bereitstellung von Hochfrequenzenergie sehr hoher Leistung gemäß einer noch weiteren Ausführungsform der Erfindung, in stark vereinfachter Prinzipdarstellung.

Es wird nun auf Ausführungsformen der Erfindung Bezug genommen, die in den Zeichnungen veranschaulicht sind. Es sollte verständlich sein, dass die in den Zeichnungen veranschaulichten Ausführungsformen lediglich beispielhaft sind und die Erfindung als solche nicht beschränken. Vielmehr sind die Ausführungsformen lediglich dazu gedacht, mögliche Ausführungsformen der Erfindung zu erläutern und den Fachmann zu befähigen, die Erfindung auszuführen. Es sollte ferner verständlich sein, dass in dem Bemühen, eine konzise Beschreibung möglicher Ausführungsformen zu liefern, gegebenenfalls nicht alle von dem Umfang der Erfindung umfassten Einzelheiten angegeben sein können.

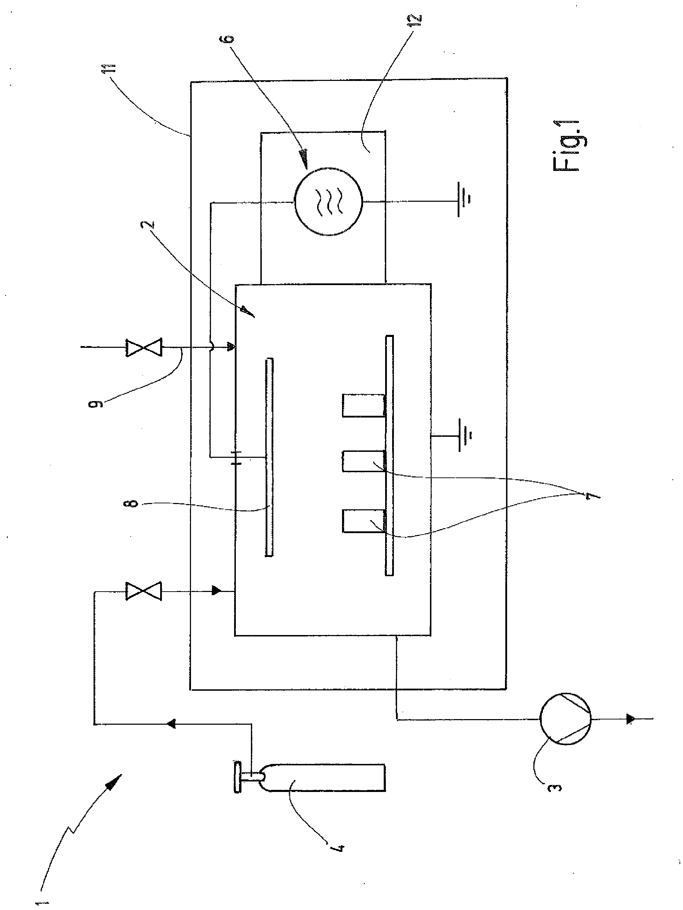

In Fig. 1 ist in einer stark vereinfachten Prinzipdarstellung ein System 1 veranschaulicht, das insbesondere hier ein Niederdruckplasmasystem zur Behandlung von Objekten ist. Ein solches System könnte bspw. zur Reinigung von Gütern aus Metall, Kunststoff, Glas oder Keramik vor einer Weiterverarbeitung, bspw. vor dem Sputtern, Lackieren, Kleben, Bedrucken, Beschichten, Löten und dgl., zur Aktivierung von Gütern vor einer Weiterverarbeitung, zum Plasmaätzen oder zum Beschichten mittels Plasmapolymerisation verwendet werden. Es sollte jedoch verständlich sein, dass das in Fig. 1 dargestellte Niederdruckplasmasystem lediglich eine bevorzugte Anwendung der Erfindung darstellt und die Erfindung auch auf andere Systeme, z.B. Gas-Lasersysteme, angewandt werden könnte.

Bezugnehmend auf Fig. 1 enthält das Niederdruckplasmasystem 1 eine Vakuumkammer 2, die auch als Rezipient bezeichnet wird und die ein ionisierbares Medium oder Prozessgas aufnimmt, eine Vakuumpumpe 3, eine Prozessgasquelle 4 und einen Hochfrequenz(HF)-Generator 6. Auf die Vakuumkammer 2 wird hier auch allgemein als Vakuumkammer Bezug genommen, um alle Kammern zu umfassen, in die HF-Energie von einem HF-Generator 6 eingekoppelt wird, um im Innern der Kammer eine elektrische Entladung herbeizuführen.

Für einen Plasmabehandlungsprozess wird ein Objekt 7 im Innern der Vakuumkammer 2 platziert, und in der Vakuumkammer 2 wird mit Hilfe der Vakuumpumpe 3 ein Unterdruck erzeugt. Bei einem Absolutdruck von ca. 0,1 Millibar wird dann das Prozessgas, z.B. Argon, Sauerstoff oder dgl. oder auch Umgebungsluft, aus der Prozessgasquelle 4 in die Vakuumkammer 2 eingeleitet. Der Arbeitsdruckbereich liegt bei ca. 0,05 bis 2,0 mbar. Wenn der Arbeitsdruck erreicht ist, wird der HF-Generator 6 zugeschaltet, der HF-Energie erzeugt und über eine Elektrode 8 in das Innere der Vakuumkammer 2 einkoppelt, um das Prozessgas anzuregen und zu ionisieren und eine elektrische Entladung herbeizuführen. Es entsteht ein Plasma, dem das Behandlungsgut ausgesetzt wird. Der Plasmaanlage wird kontinuierlich frisches Gas zugeführt, während prozessual verbrauchtes Gas mittels der Vakuumpumpe 3 abgeführt wird. Nach dem Behandlungsprozess kann über einen zusätzlichen Belüftungsanschluss 9 die Vakuumkammer belüftet werden, woraufhin die bearbeiteten Werkstücke 7 aus der Kammer 2 entnommen werden können. Soweit entsprechen der Aufbau und die Funktionsweise des Niederdruckplasmasystems 1 nach Fig. 1 denjenigen eines herkömmlichen Niederdruckplasmasystems.

Wie aus Fig. 1 ersichtlich, ist der HF-Generator 6 gemäß der Erfindung in unmittelbarer Nähe der Plasmakammer 2 angeordnet. Er kann gemeinsam mit der Plasmakammer 2 innerhalb eines gemeinsamen Gehäuses untergebracht sein, das in Fig. 1 durch ein mit 11 bezeichnetes Rechteck angedeutet ist. Die unmittelbare räumliche Nähe des HF-Generators 6 zu der Plasmakammer 2 ermöglicht es, die Länge der Leitung zur Zuführung von HF-Energie zu der Elektrode 8 der Plasmakammer 2 minimal zu halten, so dass die Elektrode 8 quasi zum integralen Teil des erfindungsgemäßen HF-Generators 6 wird und bei dessen Entwurf berücksichtigt wird. Dies gemeinsam mit einer neuen, nachfolgend näher erläuterten erfindungsgemäßen Schaltungsanordnung des HF-Generators 6 schafft die Basis dafür, dass hier auf ein Impedanzanpassungsnetzwerk (eine Matching-Einheit), wie es in herkömmlichen Systemen erforderlich ist, verzichtet werden kann und die Plasmakammer 2 mit Anregungssignalen der erforderlichen hohen Leistung und Frequenz zur stabilen Plasmaerzeugung versorgt werden kann. Das System 1 kann hinsichtlich seines Aufbaus und seiner Bedienung vereinfacht werden, wodurch die Anschaffungs- und Betriebskosten verringert werden können.

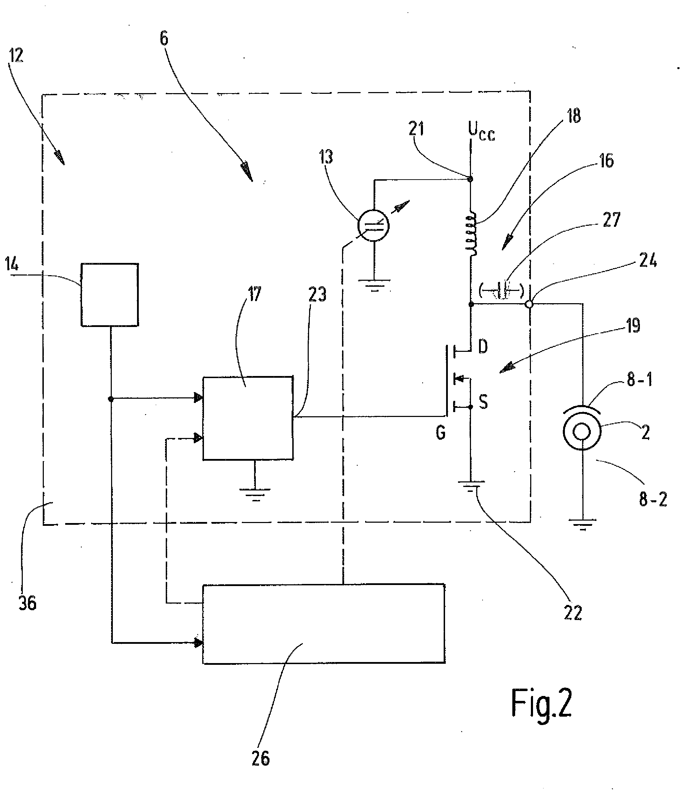

Eine beispielhafte Topologie einer Schaltungsanordnung 12 für den erfindungsgemäßen HF-Generator 6 zur Bereitstellung von HF-Energie zur Erzeugung einer elektrischen Entladung in einer Vakuumkammer, z.B. der Plasmakammer 2 nach Fig. 1, gemäß einer ersten Ausführungsform der Erfindung ist in stark vereinfachter Darstellung in Fig. 2 veranschaulicht. Die Schaltungsanordnung 12 umfasst eine Gleichspannungsversorgung 13, eine Taktgebereinheit 14, einen Hochsetzstellerschaltkreis 16 und eine Ansteuereinheit 17 für den Hochsetzstellerschaltkreis 16. Die Gleichspannungsversorgung 13 stellt eine vorzugsweise kontinuierliche Gleichspannung U_{cc} zur Versorgung der Schaltungsanordnung 12 bereit. Es kann auch eine pulsierende Gleichspannung zugeführt werden. Die Gleichspannung U_{cc} kann zwischen 0 und 400 V oder mehr betragen. Die Gleichspannung U_{cc} kann, wie durch den gestrichelten Pfeil angezeigt, variabel sein.

Die Taktgebereinheit 14 stellt einen Zeittakt für die Schaltungsanordnung 12 bereit. Insbesondere kann die Taktgebereinheit 14 Zeittaktimpulse mit einer bestimmten Frequenz liefern, die einer der für Industrie, Forschung und Medizin (ISM) freigegebenen ISM-Frequenzen von 6,78 MHz, 13,56 MHz, 27,12 MHz oder 40,68 MHz entspricht. Bevorzugterweise wird die Frequenz von 13,56 MHz verwendet. Es ist jedoch verständlich, dass eine beliebige Betriebshochfrequenz verwendet werden könnte. Als Taktgebereinheit 14 kann ein Oszillator mit einem Schwingquarz eingesetzt werden. Das Tastverhältnis der Taktgebereinheit 14 kann vorteilhafterweise unterhalb von 50 %, bspw. zwischen 30 und 50 % festgelegt sein, womit gegebenenfalls die eingebrachte Leistung reduziert werden kann.

Der Hochsetzstellerschaltkreis 16 ist nach Vorbild bekannter Hochsetzstellerschaltungen mit einer Reihenschaltung einer Induktivität 18 und eines Schalters 19 ausgebildet, die in Serie direkt miteinander verbunden zwischen einem ersten, hier positiven Pol 21 der Gleichspannungsversorgung 13 und einem Massepunkt 22 geschaltet sind. Insbesondere ist eine Klemme der Induktivität 18 mit dem positiven Pol 21 verbunden, während die andere Klemme mit einer Drain-Elektrode D des hier als n-Kanal MOSFET ausgebildeten Schalters 19 verbunden ist. Die Source-Elektrode S des Halbleiterschalters 19 ist mit dem Massepunkt 22 hier direkt verbunden. Zwischen der Source-Elektrode S und dem Massepunkt 22 könnte ein (nicht veranschaulichter) niederohmiger Shunt-Widerstand angeordnet sein, wie dies zur Stromerfassung üblich ist. Der Schalter 19 weist ferner eine Ansteuer- bzw. Gate-Elektrode G auf, die mit dem Ausgang der Ansteuereinheit 17 verbunden ist.

Wenngleich hier der Schalter S als ein MOSFET, insbesondere ein Leistungs-MOSFET, darstellt ist, ist es verständlich, dass auch andere ansteuerbare Leistungshalbleiterschalter, wie bspw. bipolare Leistungstransistoren, wenn sie entsprechend hochfrequent getaktet umschalten können, anstelle des MOSFETs für den Schalter 19 verwendet werden können. Ein Fachmann wird erkennen, dass obwohl hier auf die Elektroden mit Drain D, Source S und Gate G Bezug genommen wird, die Ausführungen in gleicher Weise für anders bezeichnete Elektroden vergleichbarer Halbleiterschalter gelten. Prinzipiell könnte der Schalter 19 auch in Form einer Elektronenröhre realisiert sein, wobei dann die Drain-Elektrode D der Anode und die Source-Elektrode S der Kathode der Elektronenröhre entsprechen. In bevorzugten Implementierungen wird hierin wegen dessen besonders geeigneter Eigenschaften vorzugsweise ein Leistungs-MOSFET auf Siliziumkarbid- oder Galliumnitridbasis eingesetzt.

Die auch als Gate-Treiber bezeichnete Ansteuereinheit 17 dient dazu, ausgehend von den von der Taktgebereinheit 14 aus empfangenen Zeittaktsignalen an deren Ausgang 23, der mit der Gate-Elektrode G des Schalters 19 verbunden ist, ein zum Einschalten des Schalters 19 geeignetes Ansteuersignal zu generieren. Im Allgemeinen wird eine Gate-Spannung von etwa 8-15 V zur Ansteuerung des Schalters 19 verwendet, um diesen einzuschalten. Es ist verständlich, dass der Schalter 19 im eingeschalteten Zustand einen Strom zwischen der Source-Elektrode S und der Drain-Elektrode D durchlässt oder leitet, während er im ausgeschalteten Zustand einen Stromfluss von der Drain-Elektrode D zu der Source-Elektrode S unterbricht oder nicht leitet. Gate-Treiber 17 sind als integrierte Schaltungen von zahlreichen Herstellern für unterschiedliche Halbleiterschalter kommerziell erhältlich.

Wie ferner aus Fig. 2 ersichtlich, ist die Drain-Elektrode D des Schalters 19 mit einem Ausgangsanschluss 24 der Schaltungsanordnung 12 verbunden. Über den Ausgangsanschluss 24 liefert die Schaltungsanordnung 12 die zum Betreiben der Plasmakammer 2 erforderliche HF-Energie, einschließlich einer HF-Spannung und eines HF-Stroms. Wie in Fig. 2 angedeutet und in Fig. 1 veranschaulicht, ist der Ausgangsanschluss 24 mit der Elektrode 8-1 der Plasmakammer 2 verbunden, um die HF-Energie in die Kammer 2 einzukoppeln. Anders als in Fig. 1 ist hier die Plasmakammer 2 keine Metallkammer, bei der die Elektrode 8-1 in den Innenraum der Plasmakammer 2 hineinragt, wie in Fig. 1 veranschaulicht, sondern bspw. eine Glaskammer, bei der die Elektroden 8-1, 8-2 an der Außenseite der Kammerwand angeordnet sind. Im vorliegenden Fall ist der Elektrode 8-1 eine Gegenelektrode 8-2 zugeordnet, die mit dem Massepotential verbunden ist. Es ist verständlich, dass hier auch die metallene Plasmakammer 2 aus Fig. 1 verwendet werden könnte. Außerdem könnten anstelle der Elektroden 8-1, 8-2 in Form von Kondensatorplatten solche in Form von Spiralspulen verwendet werden, die um die Kammerwand herum gewickelt sind, um HF-Energie in induktiver Weise in den Kammerinnenraum einzukoppeln.

Wie ferner aus Fig. 2 ersichtlich, ist eine Steuereinrichtung 26 vorgesehen, um dem Betrieb der Schaltungsanordnung 12 zu steuern. Die Steuereinrichtung 26 kann auch Teil einer Gesamtsteuerung sein, die auch den Betrieb der Plasmakammer 2 oder sogar des gesamten Niederdruckplasmasystems 1 steuert. Die Steuereinrichtung 26 kann in Form von Hard- und/oder Firmware ausgebildet sein, die bspw. auf einem Prozessor ausgeführt werden kann. Die die Hardware kann gemeinsam mit der Schaltungsanordnung 12 auf einer gemeinsamen Platine oder entfernt von dieser angeordnet sein. Jedenfalls kann die Steuereinrichtung 26 hier bspw. die Gleichspannung U_{cc} der Gleichspannungsversorgung 13 steuern bzw. regeln, die Ansteuereinheit 17 steuern, Zeittaktsignale von dem Taktgeber 14 empfangen und vorzugsweise Parameter der Schaltungsanordnung 12, insbesondere interne Ströme und Spannungen, überwachen.

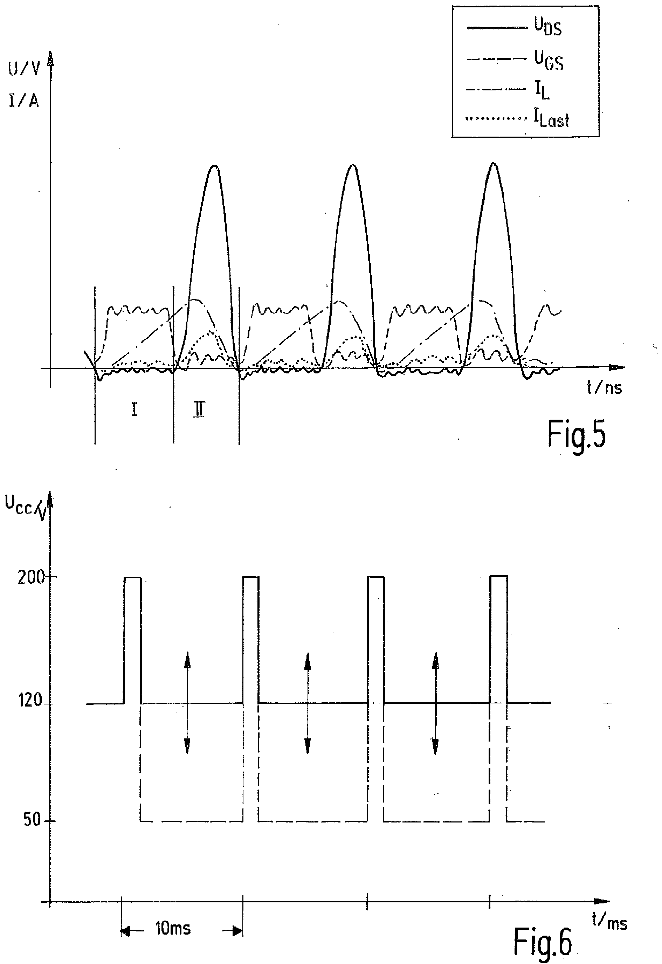

Die Funktionsweise der Schaltungsanordnung 12 für den HF-Generator 6 soll nachstehend unter Bezugnahme auf die Figuren 1 und 2 und zusätzlich auf Fig. 5 beschrieben werden, die zeitliche Spannungs- und Stromverläufe in und an der Schaltungsanordnung 12 veranschaulicht. Die soweit beschriebene Schaltungsanordnung 12 funktioniert wie folgt:
Im Abschnitt I in Fig. 5 wird der Schalter 19 mittels eines Ansteuersignals durch die Ansteuereinheit 17 eingeschaltet. Hierzu wird die Gate-Spannung U_{GS} an der Gate-Elektrode G des Schalters 19 durch die Ansteuereinheit 17 von 0 V auf z.B. 12 V gesetzt. Die Gate-Spannung U_{GS} ist in Fig. 5 durch eine gestrichelte Linie veranschaulicht. Die Drain-Spannung U_{DS}, die in Fig. 5 mit einer durchgezogenen Linie veranschaulicht ist, liegt bei dem durchgeschalteten Schalter 19 in etwa bei 0 V. Bei Einschaltung des Schalters 19 beginnt der Strom durch die Induktivität 18 zu steigen und magnetisiert die Induktivität 18 auf. Der durch die Induktivität 18 fließende Strom ist in Fig. 5 mit einer strichpunktierten Linie dargestellt. Der aus der Drain-Elektrode D des Schalters 19 zu dem Ausgangsanschluss 24 abfließende und über diesen zu der Plasmakammer 2 als Last fließende Laststrom ist in Fig. 5 mit einer punktierten Linie dargestellt. Im Zeitabschnitt I ist der Laststrom relativ gering.

Im Zeitabschnitt II wird der Schalter 19 zunächst durch die Ansteuereinheit 17 abgeschaltet. Hierzu wird die Gate-Spannung U_{GS} (gestrichelte Linie) wieder auf 0 V oder auf einen negativen Wert abgesenkt. Nachdem die Gate-Spannung U_{GS} abgefallen und eine zugehörige Signallaufzeit verstrichen ist, beginnt die Spannung U_{DS} (durchgezogene Linie) an der Drain-Elektrode D des Schalters 19 zu steigen. In dem Moment, in dem der Wert der aktuell speisenden Gleichspannung U_{cc}, die hier bspw. 100 V beträgt, überschritten wird, entlädt sich die Induktivität 18 in die Plasmakammer 2. Die Induktivität 18 magnetisiert dabei ab. Die Spannung U_{DS} an der Drain-Elektrode D und direkt am Plasma in der Plasmakammer 2 erreicht einen Spitzenwert, der hier bspw. ca. 370 V beträgt, und fällt anschließend wieder ab. In dieser Zeit wird auch der Laststrom I_{Last} (punktiert), der in die komplexe Last des Plasmas hineinfließt, maximal, so dass Leistung an das Plasma abgegeben wird.

Wie aus Fig. 5 ersichtlich, wird der Prozess, bei dem der Schalter 19 geschlossen wird, um die Induktivität 18 aufzumagnetisieren, anschließend der Schalter geöffnet wird, um eine hohe Drain-Spannung U_{DS} zu erhalten und eine Abmagnetisierung der Induktivität 18 und deren Entladung in die Plasmakammer 2 zu erzielen, periodisch mit der durch die Taktgebereinheit 14 vorgegebenen Frequenz von z.B. 13,56 MHz wiederholt, um eine periodische Anregung des Plasmas in der Plasmakammer 2 mit der erzeugten HF-Energie zu bewirken. Wie ersichtlich, entspricht dieser Prozess der typischen Funktionsweise eines Hochsetzstellers, die hier zur HF-Anregung zur Plasmaerzeugung genutzt wird.

Erfindungsgemäß wird zwar kein LC-Schwingkreis und auch kein gegengekoppelter Oszillator zur Erzeugung der periodischen HF-Energie verwendet. Es ergibt sich aber stattdessen ein Schwingkreis, der aus der Induktivität 18 und der komplexen Impedanz, insbesondere dem kapazitiven Anteil der Impedanz der Plasmakammer 2 gebildet ist. Dieser kapazitive Impedanzanteil ist vor allem durch die Konstruktion und geometrische Anordnung der Plasmakammer 2 und deren Elektroden 8, 8-1, 8-2 sowie die parasitären Kapazitäten des Schalters 19 und einer die Schaltungsanordnung 12 tragenden Platine (nicht veranschaulicht) gegen Masse bestimmt. Dieser Schwingkreis wird erfindungsgemäß dazu genutzt, einen besonders vorteilhaften, insbesondere verlustarmen Betrieb des Schalters 19 zu ermöglichen. Es findet keine Impedanzanpassung (kein Matching) statt, um die Impedanz der Plasmakammer 2 an die 50 Ohm-Bedingungen eines HF-Generators anzupassen, wie dies bei herkömmlichen HF-Generatoren erforderlich ist. Vielmehr wird hier die komplexe, kapazitätslastige Impedanz der Plasmakammer 2 Teil der Grundschaltung der Schaltungsanordnung 12 und wird in die Dimensionierungsüberlegungen mit einbezogen. Die Impedanz der Plasmakammer 2 kann unter Berücksichtigung der konstruktiven und geometrischen Anordnung der Plasmakammer und der zugehörigen Bauteile rechnerisch oder empirisch ermittelt werden. Sie wird zur Dimensionierung der Induktivität 18 mit herangezogen.

Die Induktivität 18 ist insbesondere derart zu wählen, dass sie in Kombination mit der Kapazität der Plasmakammer 2, abhängig von der individuellen geometrischen Anordnung der Kammer 2 und insbesondere der Elektroden 8, 8-1, 8-2, den parasitären Kapazitäten des Schalters 19 und der Platine gegen Masse, etc., ein Resonanzfrequenz des Quasi-Schwingkreises ergibt, die möglichst genau bei 13,56 MHz bzw. der jeweils gewünschten ISM-Frequenz liegt. Die Resonanzfrequenz könnte maximal um 50% von dem optimalen Wert abweichen. Vorzugsweise sollte sie nur minimal unter der ISM-Frequenz oder nur wenig darüber liegen, bevorzugterweise um maximal -10% bis +40% von dieser abweichen. Durch die Berücksichtigung der jeweiligen Kapazität zwischen den der Elektroden 8, 8-1, 8-2 bei der Auslegung der Induktivität 18, werden diese praktisch zum integralen Bestandteil der Schaltungsanordnung 12.

Vorzugsweise wird die Induktivität ferner so dimensioniert, dass die Drain-Spannung U_{DS}, wie auch aus Fig. 5 ersichtlich, unmittelbar vor dem Einschalten des Schalters 19 zu Null wird. Damit kann der Schalter 19 verlustfrei einschalten, wodurch ein besonders hoher Wirkungsgrad der Schaltung 12 erreicht und die Erwärmung des Halbleiterschalters 19 deutlich reduziert wird.

Zur Ermöglichung der erfindungsgemäßen Funktionsweise sollte auch der ansteuerbare Schalter 19 bestimmte Kriterien erfüllen. Bspw. sollte der Schalter 19 eine Eingangskapazität haben, die kleiner als 5 nF, vorzugsweise kleiner als 1 nF ist. Dann kann die Eingangskapazität des Schalters 19 in der für die vorliegenden Anwendungen erforderlichen, hinreichend schnellen Weise umgeladen werden. Die Anstiegs- und Fallzeiten des Schalters 19 sollten bei der vorliegenden Betriebsfrequenz vorzugsweise kleiner als 15 ns sein. Die Sperrspannung des Schalters 19 sollte möglichst größer als 500 V, vorzugsweise größer als 900 V sein, um hohe HF-Ausgangsspannungen erzeugen zu können.

Es ist ferner festgestellt worden, dass zur Erreichung eines kostengünstigen und zuverlässigen Aufbaus der Schaltungsanordnung 12 und für einen Verzicht auf Impedanzanpassungsmaßnahmen der ansteuerbare Schalter 19 derart gewählt werden sollte, dass das Verhältnis zwischen der Gate-Kapazität des Transistors zu dem Drain-Strom (bspw. bei 25°C) kleiner als 50 pF/A ist. Wird dies nicht berücksichtigt, so wird bei den vorliegenden hohen Frequenzen von z.B. 13,56 MHz die benötigte Treiberleistung so hoch, dass keine oder nur äußerst kostspielige Treiber hierfür verfügbar sind. Außerdem verschlechtert sich das Verhältnis der Treiberleistung zu der in das Plasma übertragenen Leistung ebenfalls, womit der Wirkungsgrad der Anordnung sinkt. Erfindungsgemäß kann mit korrekter Wahl des Schalters 19 und des Gate-Treibers 17 ein Verhältnis der Treiberleistung zu der in das Plasma übertragenen Leistung von mindestens 1:15 bis zu 1:20 oder mehr realisiert werden. Hierfür ist die Verwendung von SiC- oder GaN-Leistungs-MOSFETs, die die vorgenannten Eigenschaften aufweisen, besonders vorteilhaft.

Um aus der Gesamtschaltung die gewünschte hohe Leistung zu erhalten, also durch eine hohe Ausgangsspannung eine hohe Leistung in das Plasma abzugeben, ist der Schalter 19 ferner vorzugsweise derart zu wählen, dass das Verhältnis der Gate-Kapazität zu der Sperrspannung des Schalters nicht höher als 0,5 pF/V ist und die Sperrspannung mindestens 900 V beträgt. Die maximal mögliche Ausgangsspannung der Schaltungsanordnung 12 mit Schaltern mit einer maximalen Drain-Spannung U_{DSmax} von 1200 V (entsprechend einer periodischen Spitzenspannung von 900 Vₚₑₐₖ im Betrieb) muss über der Kalt-Zündspannung des Plasmas liegen. Obwohl diese Zündspannung von vielen Parametern, unter anderem vom Unterdruck in der Plasmakammer, der Gaszusammensetzung, der Kammer- und Elektrodengeometrie und dgl., abhängig ist, liegt diese Zündspannung jedoch meist über 400 V und häufig über 800 V. Insofern sollte der Schalter eine Sperrspannung von mindestens 900 V haben.

Neben den Schaltern müssen auch die Gate-Treiber 17 bestimmten Anforderungen genügen. Insbesondere sollten auch die Gate-Treiber 17 Anstiegs- und Fallzeiten haben, die kleiner als 15 ns, bevorzugt kleiner als 10 ns sind, um bei der Frequenz von 13,56 MHz arbeitsfähig zu sein. Ferner sollten die Gate-Treiber 17 eine für die anstehende Gate-Kapazität ausreichende Stromtragfähigkeit aufweisen.

Durch die Wahl und Kombination geeigneter Induktivitäten 18, Leistungshalbleiterschalter 19 (oder anderer Schalter, wie bspw. Elektronenröhren), zugehöriger Gate-Treiber 17 in Abhängigkeit von der jeweiligen Anwendung und jeweils gegebenen Geometrie und Konstruktion der Plasmakammer 2 und deren Elektroden kommt die erfindungsgemäße Schaltungsanordnung 12 für einen HF-Generator 6 ohne spezielle Resonanzkreise, ohne zusätzliche L,C-Komponenten, die die Ausgangsleistung eines herkömmlichen HF-Oszillators an die normalerweise gewünschte 50 Ohm-Ausgangsimpedanz für die Übertragung anpassen, und ohne einstellbare Bauelemente aus, die eine Impedanzanpassung der Plasmakammer 2 an die eines herkömmlichen HF-Generators vornehmen.

Die Steuereinrichtung 26 steuert den Betrieb der Schaltungsanordnung 12. Insbesondere kann die Steuereinrichtung eingerichtet sein, um einen Normalbetriebsmodus und einen Zündbetriebsmodus zu bewirken. Wie bereits erwähnt, kann die Zündspannung für das Plasma in Abhängigkeit von verschiedenen Faktoren über 400 V und gegebenenfalls weit darüber liegen. Insofern kann die Steuereinrichtung eingerichtet sein, um in einem Zündbetriebsmodus die Erzeugung einer Ausgangsspannung an dem Ausgangsanschluss 24 der Schaltungsanordnung 12 zu bewirken, die gegenüber dem Normalbetriebsmodus um ein bestimmtes Maß erhöht ist. Das erforderliche Maß der Spannungserhöhung kann bei einer bestimmten Plasmakammer 2 in Abhängigkeit von den jeweiligen Parametern der gewünschten Plasmabehandlung ermittelt werden. In bevorzugten Ausführungsformen wird die Ausgangsspannung im Zündbetriebsmodus um wenigstens 10% des Mittelwertes der Ausgangsspannung im Normalbetriebsmodus erhöht. Erreichen kann dies die Steuereinrichtung 26 z.B. durch eine kurzzeitige Erhöhung der Versorgungsspannung U_{cc} der Gleichspannungsversorgung 13.

Fig. 6 zeigt eine vorteilhafte Implementierung, bei der keine gesonderten Normalbetriebs- und Zündbetriebsmodi vorgesehen, sondern diese hier einfach ineinander verschachtelt sind. Wie zu ersehen, wird die Versorgungsspannung U_{cc} in regelmäßigen Intervallen, deren Frequenz deutlich kleiner als die HF-Frequenz der zu erzeugenden Ausgangsspannung ist, kurzzeitig von ihrem normalen Betriebsniveau auf ein höheres Zündniveau angehoben. Die kurzzeitige Spannungsüberhöhung ist so gewählt, dass sie ein sicheres Zünden oder Wiederzünden des Plasmas in der Plasmakammer 2 innerhalb kurzer Zeit bewirkt, ohne den Normalbetrieb zu beeinträchtigen. Als ein Beispiel kann die normale Versorgungsspannung U_{cc} 120 V betragen und wird z.B. auf 200 V angehoben. Die niedrige Frequenz für die Spannungsüberhöhung kann 200 Hz betragen, was einer Periode von 10 ms entspricht, während die Dauer der Spannungsüberhöhung bspw. 5-10% der Periode bzw. hier 0,5-1 ms betragen kann.

Wie ferner in Fig. 6 durch Doppelpfeile und gestrichelte Linien angezeigt, kann das normale Betriebsniveau der Versorgungsspannung U_{cc} variiert werden, um den Leistungseintrag in die Schaltungsanordnung 12 zu steuern bzw. zu regeln.

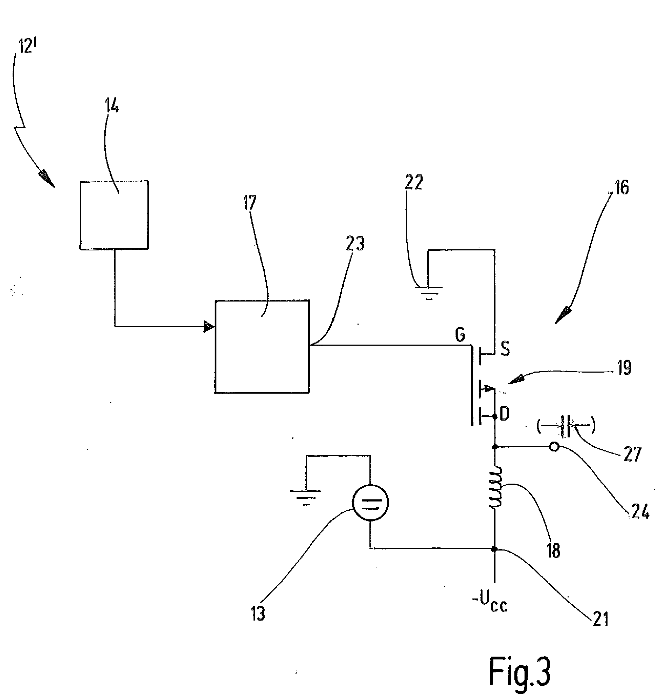

In Fig. 3 ist eine modifizierte Schaltungstopologie einer Schaltungsanordnung 12' für einen HF-Generator 6 zur Bereitstellung von HF-Energie zur Erzeugung einer elektrischen Entladung in einer Vakuumkammer, wie bspw. der Plasmakammer 2 nach Fig. 1, dargestellt. Diese Schaltungsanordnung 12' ist der Schaltungsanordnung 12 nach Fig. 2 ähnlich, so dass, soweit Übereinstimmung in Bau und/oder Funktion besteht, gleiche Bezugszeichen für gleiche Elemente in der Schaltungsanordnung 12' verwendet werden und, um Wiederholungen zu vermeiden, auf die vorstehende Beschreibung verwiesen wird.

Im Unterschied zu der Schaltungsanordnung 12 nach Fig. 2 ist die Schaltungsanordnung 12' in Fig. 3 mit einer negativen Versorgungsspannung -U_{cc} und einem p-Kanal MOSFET als Schalter 19 versehen. Die Gleichspannungsversorgung 13 liefert also an ihrem ersten, hier gegenüber dem Massepunkt 22 negativen Pol 21 eine negative Spannung -U_{cc}. Der Schalter 19 ist ein p-Kanal MOSFET, der wiederum in Reihe mit der Induktivität 18 zwischen dem Massepunkt 22 und dem negativen Pol 21 angeschlossen ist.

Im Übrigen entsprechen der Aufbau und die Funktionsweise der der Schaltungsanordnung 12' denjenigen der Schaltungsanordnung 12 nach Fig. 2. Beim eingeschalteten Schalter 19 fließt ein Source-Drain-Strom durch den Schalter 19 von dem Massepunkt 22 zu dem negativen Pol 21 und magnetisiert die Induktivität 18 auf. Wird der Schalter geschlossen, entlädt sich die Induktivität 18 und wird abmagnetisiert, wobei ein Strom von der hier nicht dargestellten Plasmakammer 2 über den Ausgangsanschluss 24 und die Induktivität 18 zum negativen Pol 21 der Gleichspannungsversorgung 13 weiter fließt, jedoch abnimmt. Es ist verständlich, dass der p-Kanal-MOSFET 19 in Fig. 3 mit einer negativen Gate-Source-Spannung U_{GS} eingeschaltet wird und die Spannung U_{DS} an der Drain-Elektrode D bzw. dem Ausgangsanschluss 24 der Schaltungsanordnung 12' im ausgeschalteten Zustand des Schalters 19 einen negativen Spitzenwert erreicht.

Wie in den Figuren 2 und 3 ersichtlich, kann zwischen dem Drain-Anschluss D des Schalters 19 und dem Ausgangsanschluss 24 optional ein Kondensator 27 angeordnet sein, um den Gleichanteil in dem der Plasmakammer 2 zugeführten oder von dieser abgeführten Laststrom herauszufiltern. Dies ist vor allem bei Verwendung einer Metallkammer 2 wichtig, wie sie in Fig. 1 veranschaulicht ist, bei der die Elektrode 8 im Innenraum der Kammer 2 angeordnet ist, so dass ohne den Kondensator 27 ein Gleichstrom direkt durch das Plasma als Kurzschlussstrom abfließen könnte. Es könnten weitere Komponenten, insbesondere LC-Filter vor oder hinter dem Ausgangsanschluss 24 in der zu der Plasmakammer 2 führenden Verbindungsleitung angeordnet sein, um bestimmte Frequenzbereiche, z.B. Harmonische, aus dem erzeugten HF-Leistungssignal zu entfernen. Solche LC-Filter sind dann aber nur zur Filterung des Ausgangssignals bestimmt und eingerichtet und nicht bemessen, um eine gewünschte Resonanzfrequenz zu erzeugen.

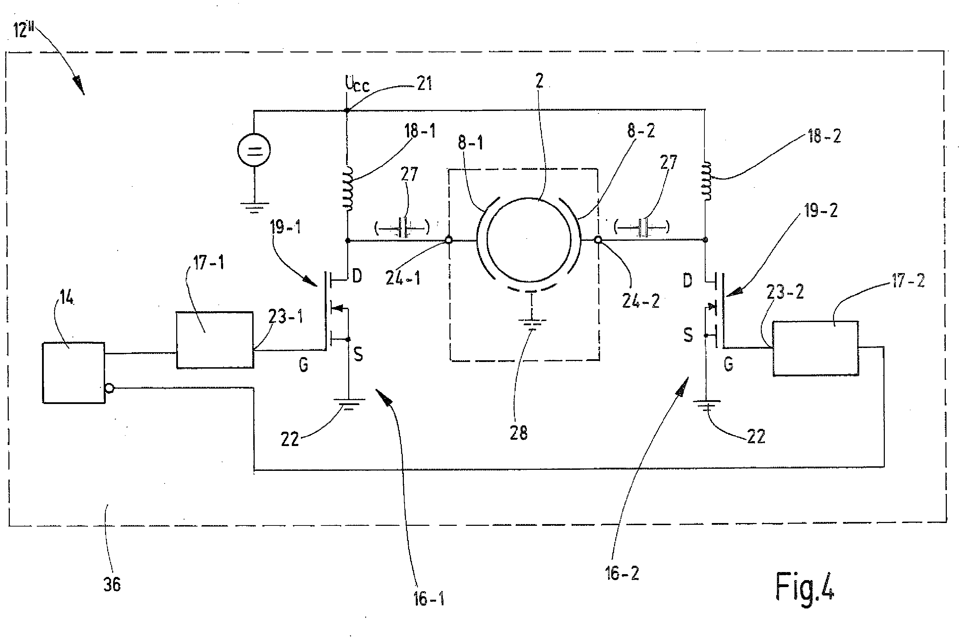

Eine weitere Schaltungsanordnung 12" zur Bereitstellung von Hochfrequenzenergie zur Erzeugung einer elektrischen Entladung in einer Vakuumkammer, insbesondere in der Plasmakammer 2 nach Fig. 1, ist in vereinfachter Darstellung in Fig. 4 veranschaulicht. Diese Schaltungsanordnung 12" unterscheidet sich von derjenigen nach Fig. 2 insofern, als hier zwei Hochsetzstellerschaltkreise 16-1, 16-2 vorgesehen sind. Die Hochsetzstellerschaltkreise 16-1, 16-2 sind identisch mit einer Reihenschaltung einer Induktivität 18-1 bzw. 18-2 mit zugehörigem Schalter 19-1, 19-2, die zwischen einer gemeinsamen Gleichspannungsversorgung 13 und einem Massepunkt 22 angeordnet sind, ausgebildet. Im vorliegenden Fall sind die Schalter 19-1, 19-2 durch n-Kanal-MOSFETs gebildet, könnten jedoch entsprechend der Ausführungsform nach Fig. 3 auch p-Kanal MOSFETs sein. Jedem Schalter 19-1, 19-2 ist eine zugehörige Ansteuereinheit bzw. ein Gate-Treiber 17-1 bzw. 17-2 zugeordnet.

Ein Ausgang einer Taktgebereinheit 14 ist mit der ersten Ansteuereinheit 17-1 verbunden, während ein zweiter, invertierter Ausgang der Taktgebereinheit 14 mit der zweiten Ansteuereinheit 17-2 verbunden ist. Somit werden die Schalter 19-1, 19-2 jeweils um 180° phasenversetzt getaktet. Während einer jeweiligen Phase, in der einer der Schalter 19-1, 19-2 ausgeschaltet ist, und eine hohe Spannung sowie ein hoher Laststrom über den Ausgangsanschluss 24-1 bzw. 24-2 an die Elektrode 8-1 bzw. 8-2 angelegt wird, dient jeweils die gegenüberliegende Elektrode 8-2, 8-1 und der daran angeschlossene Schalter 19-2 bzw. 19-1 als die Masseelektrode, da die Elektrode 8-2 bzw. 8-1 in dieser Phase gegen Masse geschaltet ist. Vorteilhafterweise ist bei dieser Ausbildung eine Masseelektrode für die Plasmakammer 2 nicht mehr erforderlich, wie dies durch die gestrichelt eingezeichnete Masseelektrode 28 in Fig. 4 angedeutet ist. Mit dieser Grundschaltung können auch komplexere Geometrien der Plasmakammer 2 realisiert werden, und die aktive Elektrodenfläche an der Kammer 2 kann verdoppelt werden.

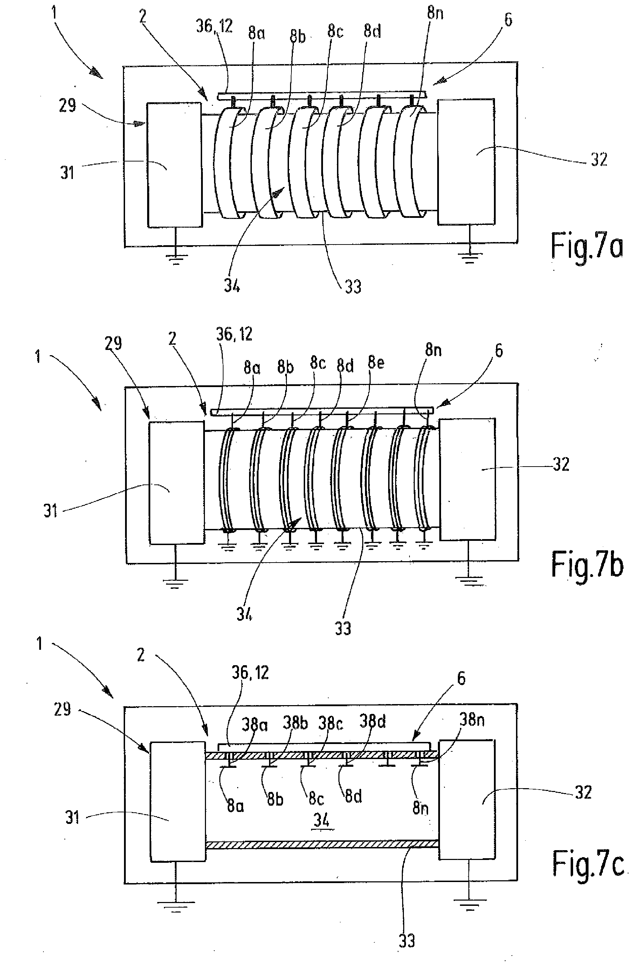

Figuren 7a-7c zeigen bevorzugte Realisierungsformen erfindungsgemäßer Niederdruckplasmasysteme 1, die eine besonders vorteilhafte kompakte und verlustarme Realisierung ermöglichen. Dargestellt ist jeweils eine längliche Plasmakammer 2 mit einem Kammergehäuse 29, zu dem ein erstes, vorderes Gehäuseteil 31, ein zweites, hinteres Gehäuseteil 32 und eine Kammerwand 33 gehören, die zwischen dem ersten und dem zweiten Gehäuseteil 31, 32 in Längsrichtung der Plasmakammer 2 verläuft und einen Innenraum 34 der Plasmakammer 2 umgibt. Die Gehäuseteile 31, 32 und die Kammerwand 33 können im Querschnitt bspw. kreisförmig, quadratisch oder rechteckig ausgebildet sein oder andere geeignete Querschnittsformen aufweisen.

Fig. 7a zeigt eine Ausführungsform, bei der die Kammerwand 33 bspw. aus Glas, vorzugsweise Quarzglas oder Borosilikatglas, ausgebildet ist und eine Reihe von Elektroden 8a, 8b, ... 8n an der Außenseite der Kammerwand 33 angeordnet ist. Die Elektroden 8a-n sind in Längsrichtung der Plasmakammer 2 gleichmäßig verteilt und äquidistant angeordnet. Obwohl die Elektroden 8a-n hier veranschaulicht sind, wie sie im Wesentlichen in Form von dünnen, flachen Metallringen ausgebildet und um die Kammerwand 33 herum angeordnet sind, können die Elektroden 8a-n alternativ im Wesentlichen plattenförmig ausgebildet und in einer linearen Reihe in Längsrichtung der Plasmakammer 2 oberhalb, unterhalb oder auch an einer Seite der Kammerwand 33 angeordnet sein. Jedenfalls ist vorzugsweise eine entsprechende Anzahl und Anordnung der Elektroden 8a-n vorgesehen, um eine weitgehend homogene Anregung des Plasmas in dem Innenraum 34 durch die Elektroden 8a-n zu bewirken. Die Gegenelektrode kann bspw. durch das metallene hintere Gehäuseteil 32 des Kammergehäuses 29 gebildet sein. Das vordere Gehäuseteil 32 kann zur Beladung von Werkstücken mit einer Tür versehen sein.

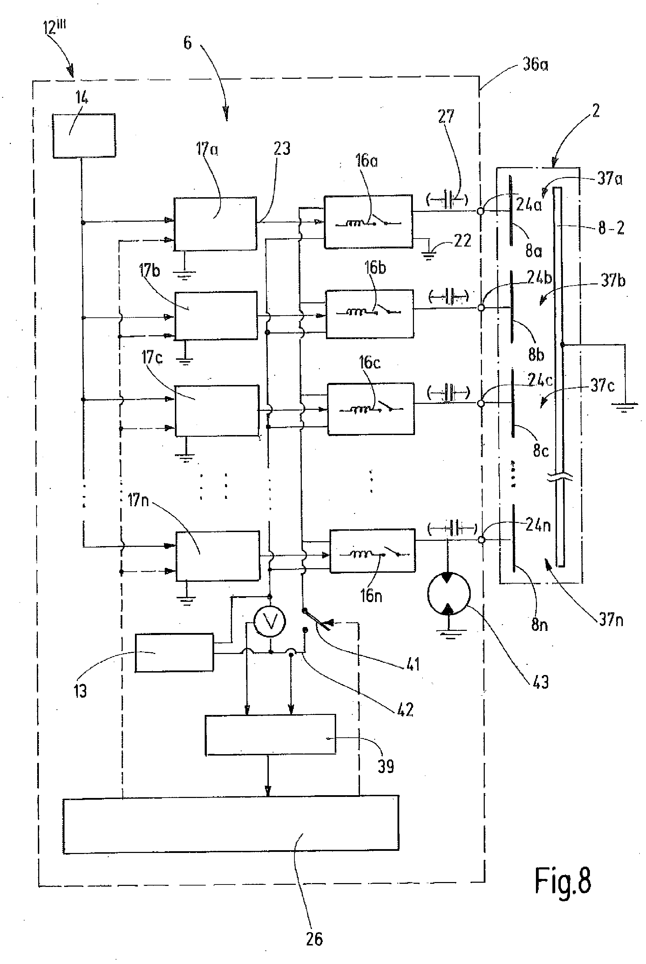

Ferner ist in Fig. 7a eine Platine 36 in unmittelbarer Nähe der Elektroden 8a-n angeordnet. Die Platine 36 weist eine Schaltungsanordnung 12'" zur Bereitstellung von Hochfrequenzenergie für die Plasmakammer 2 auf, die auf einer der Grundschaltungen 12, 12' bzw. 12" der Figuren 2 bis 4 basiert. Die Schaltungsanordnung 12'" ist im Detail in Fig. 8 veranschaulicht.

Bezugnehmend auf Fig. 8 weist die Schaltungsanordnung 12'" eine Taktgebereinheit 14 auf, die ein Zeittaktsignal an mehrere vorhandene Ansteuereinheiten 17a, 17b ... 17n liefert. Die Zeittaktsignale werden an alle vorhandenen Ansteuereinheiten 17a-n synchron, insbesondere innerhalb einer Phasenabweichung von maximal 10%, vorzugweise weniger als 2%, geliefert. Dies kann durch Abstimmung der Leitungslängen zu den Ansteuereinheiten 17a-n erreicht werden.

Jede Ansteuereinheit 17a-n ist mit einem zugehörigen Hochsetzstellerschaltkreis 16a-n verbunden, den die Ansteuereinheit jeweils ansteuert. Die Kombination aus jeder Ansteuereinheit 17a-n und zugehörigem Hochsetzstellerschaltkreis 16a-n kann wie in Fig. 2 oder in Fig. 3 gestaltet sein. Alternativ kann diese Kombination durch die Kombination aus zwei Schaltkreis- und Elektrodenpaaren ersetzt werden, die jeweils um 180° phasenversetzt getaktet werden, wie in Fig. 4 dargestellt.

Die Hochsetzstellerschaltkreise 16a-n sind, gegebenenfalls unter Zwischenschaltung eines Gleichstromblockierkondensators 27 oder anderer LC-Filter, sofern erforderlich, und über die zugehörigen Ausgangsanschlüsse 24a-n jeweils mit der zugehörigen Elektrode 8a-n und dem zugehörigen Lastabschnitt bzw. Abschnitt 37a-n der Plasmakammer 2 verbunden.

Zurückkehrend zu Fig. 7a ist ersichtlich, dass die Platine 36 hier in unmittelbarer Nähe zu den Elektroden 8a-n angeordnet ist. Damit können äußerst kurze Leitungswege zwischen den Drain-Elektroden D der jeweiligen Schalter 19a-n und den zugehörigen Elektroden 8a-n realisiert werden, die kürzer als 100 cm, vorzugsweise kürzer als 20 cm, bevorzugterweise kürzer als 12 cm oder nur wenige Zentimeter kurz sind. In besonders bevorzugten Ausführungsformen sind die Ausgangsanschlüsse 24a-n direkt mit den Elektroden 8a-n der Plasmakammer 2 verbunden, z.B. verlötet. Zusätzliche Kabelleitungen zwischen den Ausgangsanschlüsse 24a-n und den Elektroden 8a-n können entfallen, und die Leitungsimpedanzen sind vernachlässigbar. Gegebenenfalls kann eine kurze, impedanzarme Zwischenverbindung über flache Kupferstreifen oder dgl. vorgesehen sein.

Alternativ oder zusätzlich kann das Niederdruckplasmasystem 1 nach Fig. 7a von einem gemeinsamen Gehäuse 11 eingehaust sein, das sowohl die Plasmakammer 2 als auch die Platine 36 mit der Schaltungsanordnung 12"' aufnimmt.

Obwohl das in Fig. 7a nicht veranschaulicht ist, kann die Anordnung der Platine 36 und der Bauelemente an dieser ferner derart implementiert sein, dass jeder Schalter 19a-n der Schaltungsanordnung 12'" mit zugehöriger Elektrode 8a-n wärmeleitend verbunden ist. Bspw. kann der Schalter 19a-n direkt an der zugehörigen Elektrode 8a-n angebracht sein. Alternativ kann ein gut wärmeleitendes Verbindungselement dazwischen eingefügt sein. Jedenfalls können die Elektroden 8a-n der Plasmakammer 2 dann als Kühlkörper für die Schalter 19a-n dienen, um die bei dem hochfrequenten Betrieb entstehende Wärme wirkungsvoll abzuführen.

Fig. 7b zeigt eine der Fig. 7a ähnliche Anordnung, jedoch mit einer induktiven Einkopplung von HF-Energie in die Plasmakammer 2. Die Elektroden 8a-n sind hier durch spiralförmige Spulen gebildet, die die Kammerwand 33 der Glaskammer 2 mit jeweils einer oder mehreren Windungen umgeben. Die Elektroden 8a-n sind wiederum äquidistant, gleichmäßig verteilt entlang der Längsrichtung der Plasmakammer 2 angeordnet, um ein homogenes Plasma zu erzeugen. Die Platine 36 mit der Schaltungsanordnung zur HF-Energieversorgung der Plasmakammer 2, insbesondere mit der Schaltungsanordnung 12'" nach Fig. 8, ist aus den vorstehend angegebenen Gründen wiederum in unmittelbarer Nähe zu den Elektroden 8a-n angeordnet. Um Wiederholungen zu vermeiden, wird auf die vorstehenden Ausführungen zu der Ausführungsform nach Fig. 7a zu den kurzen, impedanzarmen Verbindungswegen, dem möglichen gemeinsamen Gehäuse 11 und der möglichen Verwendung der Elektroden 8a-n als Kühlkörper für die Schalter 19a-n Bezug genommen, die hier entsprechend gelten.

Fig. 7c zeigt eine der Fig. 7a ähnliche Anordnung mit kapazitiver Einkopplung von HF-Energie in die Plasmakammer 2, jedoch für eine Metallkammer 2 und mit direkter Einkopplung. Die Kammerwand 33 ist folglich aus Metall, vorzugsweise aus Aluminium oder aus Edelstahl ausgebildet, und die Elektroden 8a-n sind in dem Innenraum 34 wiederum äquidistant, gleichmäßig verteilt entlang der Längsrichtung der Plasmakammer 2 angeordnet. Die Elektroden 8a-n sind über die Zuführleitungen 38a-n, die durch die Kammerwand 33 hindurchgeführt sind, mit der Platine 36 verbunden, die die Schaltungsanordnung zur HF-Energieversorgung der Plasmakammer 2, insbesondere die Schaltungsanordnung nach Fig. 8, trägt. Durch eine unmittelbare Nähe der Platine 36 zu den Elektroden 8a-n können die Zuführleitungen 38a-n wiederum sehr kurz und impedanzarm ausgeführt sein. Es kann ein gemeinsames Gehäuse 11 für das Niederdruckplasmasystem 1 vorgesehen sein. Außerdem kann jeder Schalter 19a-n auf der Platine 36 für Kühlzwecke mit der metallenen Kammerwand 33 wärmeleitend verbunden sein, wobei dazwischen z.B. eine dünne, gut wärmeleitende, elektrisch isolierende Zwischenschicht eingefügt sein kann.

Im Rahmen der Erfindung sind noch weitere Modifikationen möglich. Bspw. zeigt Fig. 8, dass eine Überwachungsvorrichtung 39 vorgesehen sein kann, die dazu eingerichtet ist, Spannungen und Ströme in der Schaltungsanordnung 12, 12', 12" bzw. 12'" (nachfolgend einfach als Schaltungsanordnung 12 bezeichnet) zu erfassen und hierfür kennzeichnende Signale an die Steuereinrichtung 26 zu senden. Diese Messsignale können durch die Steuereinrichtung 26 verwendet werden, um unzulässige Überströme oder Überspannungen zu erkennen und daraufhin Schutzmaßnahmen zum Schutz der Bauelemente der Schaltungsanordnung 12 einzuleiten. Z.B. kann die Steuereinrichtung 26 eine Logik enthalten, die eine Schutzeinrichtung zur Überstromabschaltung implementiert, die allen Schaltern 19a-n der Hochsetzstellerschaltkreise 16a-n vorgelagert und gemeinsam ist und die bei Überschreitung einer vorgebbaren maximalen Stromaufnahme der Gesamtschaltung durch Öffnen eines Trennschalters 41 in der gemeinsamen Versorgungsleitung 42 zu den Hochsetzstellerkreisen 16a-n die Stromversorgung dauerhaft oder für einen definierten Zeitraum unterbricht. Dies ist insbesondere für den Fall unverhoffter Kurzschlüsse in der Kammer 2, die bspw. durch umfallende behandelte Objekte im Innenraum 34 der Plasmakammer 2 hervorgerufen werden können, zum Schutz von Komponenten und des gesamten Systems 1 von Vorteil. Der Trennschalter 41 könnte auch bei Erkennung einer Überspannung an der gemeinsamen Versorgungsleitung 42 zum Schutz der Komponenten getrennt werden.

Alternativ oder zusätzlich kann die Steuereinrichtung 26 eine Logik enthalten, die eine Überspannungsschutzeinrichtung implementiert, die in der Lage ist, eine Überspannung abzubauen. Bspw. kann, wie an dem Schalter 19n in Fig. 8 exemplarisch veranschaulicht, eine zündbare Entladungsstrecke, z.B. sog. Schaltfunkenstrecke 43, an dem Ausgang eines jeden Schalters 19a-b vorgesehen sein, die parallel zu dem jeweils zu schützenden Hochsetzstellerschaltkreis 16a-n angeordnet ist. Bei einer Überspannungsbedingung an einem des Ausgänge 24a-n kann die jeweilige Entladungsstrecke 43 selbsttätig zünden, um die Überspannung abzubauen. Alternativ könnte auch die Steuereinrichtung 26 eine Überspannungsbedingung erkennen und die entsprechende Entladungsstrecke 43 zünden. Derartige Überspannungsableiter auf Basis von Entladungsstrecken bzw. Schaltfunkenstrecken sind in der Technik allgemein bekannt und hier verwendbar.

Noch weiter kann optional eine Schutzeinrichtung gegen Übertemperatur vorgesehen sein.

Darüber hinaus ist es möglich, die Schaltungsanordnung 12'" nach Fig. 8 auf zwei oder mehrere Platinen 36i (1=1..m) verteilt anzuordnen (hier nicht veranschaulicht). Dadurch kann auch eine sehr große Plasmakammer 2 mit einer Vielzahl von Elektroden 8a-n homogen und mit sehr hoher HF-Energie angeregt werden. Die Platinen 36i können parallel zueinander geschaltet, jeweils von einer eigenen Gleichspannungsversorgung 13 gespeist und von einer gemeinsamen Taktgebereinheit 14 mit gemeinsamem Zeittaktsignal versorgt sein. In einer besonders bevorzugten Ausführungsform können die Leitungsverbindungen geeignet geführt und Zeitverzögerungsglieder in die Leitungsverbindungen aufgenommen sein um sicherzustellen, dass ein gemeinsamer Zeittakt allen Ansteuereinheiten 17a-n auf allen Platinen 36i weitgehend synchron zugeführt wird. Ein Schutz gegen Überspannung, Überstrom und/oder Übertemperatur ist vorzugsweise für jede Platine 36i gesondert vorgesehen.

Unabhängig davon, wie viele Platinen verwendet werden, bieten die mehreren Schalter 19a-n auch eine vorteilhafte Redundanz. Bei Ausfall einzelner Schalter 19a-n können andere Schalter weiter betrieben werden, so dass Segmente der Plasmakammer 2 weiterhin mit HF-Energie versorgt werden, wobei die Homogenität der Plasmaerzeugung gegebenenfalls nur unwesentlich beeinträchtigt wird.

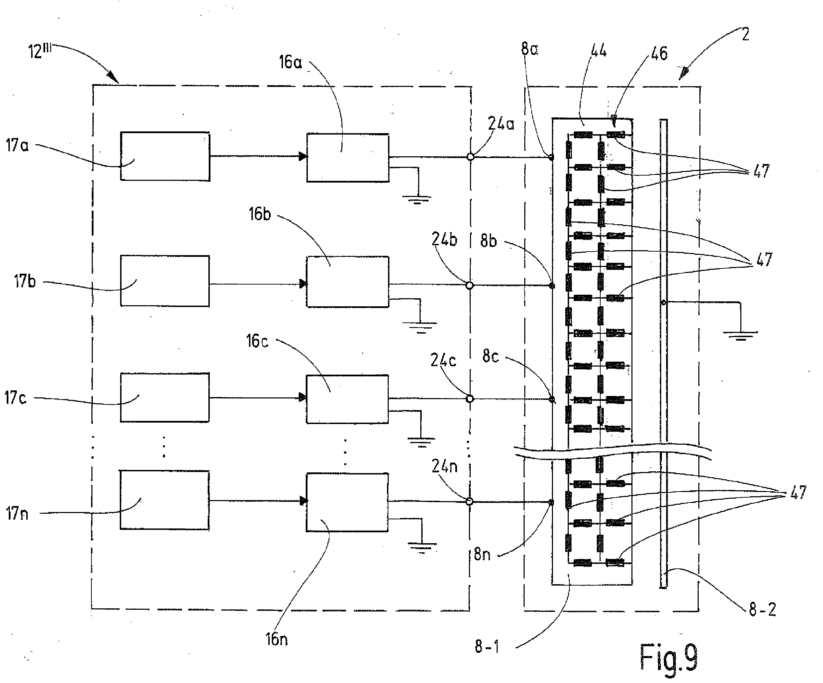

In einer weiteren, in Fig. 9 veranschaulichten Ausführungsform der Erfindung können die Elektroden 8a-n eines der vorstehend erläuterten Niederdruckplasmasysteme 1 bspw. über ein dünnes, flaches Blech 44 miteinander elektrisch leitend verbunden werden, um eine einzige gemeinsame aktive Elektrode 8 für die Plasmakammer 2 zu bilden. Dadurch kann z.B. mittels der Schaltungsanordnung 12'" eine deutlich höhere, kumulierte HF-Leistung an die Plasmakammer angelegt werden, die auch 10 kW oder mehr betragen könnte. Außerdem kann die HF-Leistung im Vergleich zur punktförmigen Einspeisung über die vergrößerte Elektrode 8 hinweg homogener und synchroner eingespeist werden, was die Homogenität der erzeugten Plasmas verbessern kann. Obwohl die Elektroden 8a-n bzw. die Ausgangsanschlüsse 24a-n der Schaltungsanordnung 12'" hier galvanisch verbunden sind, ist dies bei der Betriebsfrequenz der an die Ausgangsanschlüsse 24a-n angelegten Ausgangsspannung unerheblich. Das Blech 44 kann für die Hochfrequenz als ein Netzwerk 46 einer Vielzahl in Reihe und parallel miteinander verbundener Induktivitäten 47 angesehen werden, so dass HF-technisch kein Kurzschluss besteht.

Es ist eine Schaltungsanordnung 12 zur Bereitstellung von Hochfrequenzenergie zur Erzeugung einer elektrischen Entladung in einer Vakuumkammer 2, insbesondere zur Plasmaerzeugung, geschaffen, die eine Gleichspannungsversorgung 13, einen Hochsetzstellerschaltkreis 16 und eine Ansteuereinheit 17 aufweist. Die Gleichspannungsversorgung 13 stellt eine Gleichspannung U_{cc} bereit. Der Hochsetzstellerschaltkreis 16 enthält eine Reihenschaltung aus einer Induktivität 18 und einem ansteuerbaren Schalter 19, wobei die Induktivität 18 zwischen einem Pol 21 der Gleichspannungsversorgung 13 und einer ersten Elektrode D des Schalters 19 angeschlossen ist. Eine zweite Elektrode S des Schalters 19 ist gegen Masse geschaltet, und der Schalter 19 weist ferner eine Steuerelektrode G auf. Die Ansteuereinheit 17 ist eingerichtet, um den Schalter 19 hochfrequent anzusteuern, um an der ersten Elektrode D des Schalters 19 Hochfrequenzenergie mit einer periodischen, impulsartigen Ausgangspannung U_{DS} zu erzeugen, deren Spitzenbetrag größer ist als der Betrag der Gleichspannung U_{cc} der Gleichspannungsversorgung 13. Die Hochfrequenzenergie mit der Ausgangspannung U_{DS} wird unmittelbar, ohne Transformation an einem Ausgangsanschluss 24 ausgegeben, der zur direkten Verbindung mit einer Elektrode 8 der Vakuumkammer 2 bestimmt ist. Ein System zur Erzeugung einer elektrischen Entladung, insbesondere Niederdruckplasmasystem, mit einer derartigen Schaltungsanordnung 12 ist ebenfalls geschaffen.

## Patentansprüche

1. Schaltungsanordnung zur Bereitstellung von Hochfrequenzenergie zur Erzeugung einer elektrischen Entladung in einer Vakuumkammer, insbesondere zur Plasmaerzeugung,
mit einer Gleichspannungsversorgung (13), die eine Gleichspannung (U_{cc}) bereitstellt;
mit einem Hochsetzstellerschaltkreis (16), der eine Reihenschaltung aus einer Induktivität (18) und einem ansteuerbaren Schalter (19) enthält, wobei die Induktivität (18) zwischen einem Pol (21) der Gleichspannungsversorgung (13) und einer ersten Elektrode (D) des Schalters (19) angeschlossen ist, wobei eine zweite Elektrode (S) des Schalters (19) gegen Masse geschaltet ist und wobei der Schalter (19) ferner eine Steuerelektrode (G) aufweist;
mit einer Ansteuereinheit (17), die eingerichtet ist, um den Schalter (19) hochfrequent anzusteuern, um an der ersten Elektrode (D) des Schalters (19) Hochfrequenzenergie mit einer periodischen, impulsartigen Ausgangspannung (U_{DS}) zu erzeugen, deren Spitzenbetrag größer ist als der Betrag der Gleichspannung (U_{cc}) der Gleichspannungsversorgung (13), und
mit einem Ausgangsanschluss (24), der zur direkten Verbindung mit einer Elektrode (8) der Vakuumkammer (2) ohne Zwischenschaltung eines Impedanzanpassungsnetzwerkes bestimmt und mit der ersten Elektrode (D) des Schalters (19) verbunden ist, um die Hochfrequenzenergie mit der Ausgangsspannung (U_{DS}) an die Vakuumkammer (2) anzulegen.

2. Schaltungsanordnung nach Anspruch 1, **dadurch gekennzeichnet, dass** sie frei von einem aus einer Spule und einem Kondensator oder durch Rückkopplung gebildeten Resonanzkreis ist, der mit dem Schalter (19) gekoppelt ist und/oder durch den Schalter (19) angeregt wird, um eine am Ausgangsanschluss anliegende HF-Wechselspannung zu erzeugen, und dass sie frei von insbesondere einstellbaren Bauelementen ist, die zur Impedanzanpassung des Ausgangs des Schalters (19) an eine an den Ausgangsanschluss (24) anzuschließende Last dienen.

3. Schaltungsanordnung nach Anspruch 1 oder 2, **dadurch gekennzeichnet, dass** sie für den Betrieb an Niederdruckplasmasystemen eingerichtet ist, die eine Plasmakammer (2) mit einem Betriebsdruck aufweisen, der kleiner ist als der Atmosphärendruck, vorzugsweise etwa 0,01 mbar bis 200 mbar, besonders bevorzugt etwa 0,05 bis 2 mbar beträgt.

4. Schaltungsanordnung nach einem der vorhergehenden Ansprüche, **dadurch gekennzeichnet, dass** die Gleichspannung im Bereich von 0 bis 400 Volt liegt, die Ausgangsspannung (U_{DS}) Spitzenwerte aufweist, die im Bereich von 250 bis 900 Volt oder darüber liegen, vorzugsweise mehr als 350 Volt betragen, und die Ansteuerfrequenz und die Frequenz der Ausgangsspannung (U_{DS}) eine ISM-Frequenz (f_{ISM}) ist, die aus 6,78 MHz, 13,56 MHz, 27,12 MHz und 40,68 MHz ausgewählt ist, vorzugsweise 13,56 MHz beträgt.

5. Schaltungsanordnung nach einem der vorhergehenden Ansprüche, **dadurch gekennzeichnet, dass** die Induktivität (18) derart bemessen ist, dass sich in Kombination mit dem kapazitiven Anteil der Impedanz der Vakuumkammer (2), die im Wesentlichen durch die Konstruktion und geometrische Anordnung der Vakuumkammer (2), deren Elektroden (8), die parasitären Kapazitäten des Schalters (19) und einer die Schaltungsanordnung (12) tragenden Platine gegen Masse bestimmt ist, eine Resonanzfrequenz ergibt, die im Bereich von 0,5 x f_{ISM} bis 1,5 x f_{ISM}, vorzugsweise im Bereich von 0,9 x f_{ISM} bis 1,4 x f_{ISM}, liegt, wobei f_{ISM} die Frequenz der Ausgangsspannung (U_{DS}) ist.

6. Schaltungsanordnung nach einem der vorhergehenden Ansprüche, **dadurch gekennzeichnet, dass** der ansteuerbare Schalter (19) ein Leistungshalbleiterschalter, insbesondere ein Bipolartransistor oder eine Elektronenröhre ist, wobei der Schalter (19) vorzugsweise ein Leistungs-MOSFET, besonders bevorzugt ein Siliziumkarbid- oder Galliumnitrid-Leistungs-MOSFET, ist.

7. Schaltungsanordnung nach einem der vorhergehenden Ansprüche, **dadurch gekennzeichnet, dass** der ansteuerbare Schalter (19) eine Eingangskapazität, die kleiner als 5 nF, vorzugsweise kleiner als 1 nF ist, eine Sperrspannung, die größer als 500 V, vorzugsweise größer als 900 V ist, und Anstiegszeiten und Fallzeiten aufweist, die kleiner als 15 ns sind.
wobei die Ansteuereinheit (17) vorzugsweise als integrierte Schaltung ausgebildet ist, die eingerichtet ist, um den Schalter (19) mit einem Ansteuerstrom von weniger als 10 A, vorzugsweise weniger als 5 A anzusteuern.

8. Schaltungsanordnung nach einem der vorhergehenden Ansprüche, **dadurch gekennzeichnet, dass** eine Steuereinrichtung (26) für den Betrieb der Schaltungsanordnung (12) vorgesehen ist, wobei die Steuereinrichtung (26) vorzugsweise eingerichtet ist, um einen Zündbetriebsmodus zu bewirken, in dem die erzeugte Ausgangsspannung (U_{DS}) gegenüber dem Normalbetriebsmodus um ein Maß, vorzugsweise um wenigstens 10% des Mittelwertes der Ausgangsspannung im Normalbetriebsmodus, erhöht ist.

9. Schaltungsanordnung nach Anspruch 8, **dadurch gekennzeichnet, dass** die Steuereinrichtung (26) eingerichtet ist, um den Zündbetriebsmodus periodisch, mit einer Frequenz, die deutlich kleiner ist als die Betriebshochfrequenz, vorzugsweise mit einer Frequenz von etwa 100 Hz, im laufenden Betrieb zu bewirken.

10. Schaltungsanordnung nach einem der vorhergehenden Ansprüche, **dadurch gekennzeichnet, dass** sie zwei oder mehrere an eine gemeinsame Gleichspannungsversorgung angeschlossene Hochsetzstellerschaltkreise (16a-n) mit zugehörigen Ausgangsanschlüssen (24a-n) zur Ankopplung von Hochfrequenzenergie an die Vakuumkammer (2) und eine Anzahl Ansteuereinheiten (17a-n) aufweist, die jeweils einem oder zwei Hochsetzstellerschaltkreisen (16a-n) zugeordnet sind.

11. Schaltungsanordnung nach Anspruch 10, **dadurch gekennzeichnet, dass** sie eine Taktgebereinheit (14) aufweist, die ein Zeittaktsignal an alle vorhandenen Ansteuereinheiten (17a-n) derart liefert, dass diese synchron, innerhalb einer Phasenabweichung von maximal 10°, vorzugsweise weniger als 2°, betrieben werden.

12. Schaltungsanordnung nach einem der vorhergehenden Ansprüche, **dadurch gekennzeichnet, dass** sie eine oder mehreren der folgenden Schutzeinrichtungen aufweist:
eine allen Schaltern (19) der Hochsetzstellerschaltkreise (16) vorgelagerte, gemeinsame Schutzeinrichtung zur Überstromabschaltung, die bei einer festlegbaren Stromaufnahme der Gesamtschaltung die Stromversorgung unterbricht;
eine Überspannungsschutzeinrichtung, die eine Entladungsstrecke (43) aufweist, die im Falle einer Überspannung zündet oder gezündet wird, um die Überspannung abzubauen; und/oder
eine Schutzeinrichtung gegen Übertemperatur.

13. System zur Erzeugung einer elektrischen Entladung, insbesondere Niederdruckplasmasystem,
mit einer Vakuumkammer (2), insbesondere Plasmakammer, zur Aufnahme eines ionisierbaren Mediums, wobei die Vakuumkammer (2) eine Anzahl Elektroden (8) aufweist, um Hochfrequenzenergie induktiv, kapazitiv oder direkt in das ionisierbare Medium einzukoppeln; und
mit einer Schaltungsanordnung (12) zur Bereitstellung von Hochfrequenzenergie nach einem beliebigen der vorhergehenden Ansprüche, wobei jeder Ausgangsanschluss (24) der Schaltungsanordnung (12) direkt, ohne Zwischenschaltung eines Impedanzanpassungsnetzwerkes mit einer Elektrode (8) der Vakuumkammer (2) verbunden ist.

14. System nach Anspruch 13, **dadurch gekennzeichnet, dass** die Schaltungsanordnung (12) auf einer Platine (36) implementiert ist, die in unmittelbarer Nähe zu der Vakuumkammer (2) angeordnet und vorzugsweise mit dieser in einem gemeinsamen Gehäuse (11) untergebracht ist.

15. System nach Anspruch 13 oder 14, **dadurch gekennzeichnet, dass** die elektrische Verbindungsstrecke zwischen der ersten Elektrode (D) eines jeden ansteuerbaren Schalters (19) der Schaltungsanordnung (12) und der zugehörigen Elektrode (8) der Vakuumkammer (2) kürzer als 100 cm, vorzugsweise kürzer als 20 cm, besonders bevorzugt kürzer als 12 cm, ist; und/oder
wobei die Induktivität der Verbindungsstrecke zwischen der ersten Elektrode (D) eines jeden ansteuerbaren Schalters (19) der Schaltungsanordnung (12) und der zugehörigen Elektrode (8) der Vakuumkammer (2) weniger als 10 µH, vorzugsweise weniger als 1 µH, besonders bevorzugt weniger als 250 nH beträgt.

16. System nach einem der Ansprüche 13-15, **dadurch gekennzeichnet, dass** die Vakuumkammer eine Kammerwand (33) aus Glas, vorzugsweise Quarzglas oder Borosilikatglas, aufweist, die den Innenraum (34) der Vakuumkammer (2) umgibt, wobei die Elektroden (8a-n) an der Außenseite der Kammerwand (33) angeordnet und vorzugsweise äquidistant entlang einer Längsrichtung der Vakuumkammer (2) vorgesehen sind.

17. System nach Anspruch 16, **dadurch gekennzeichnet, dass** jeder Schalter (19a-n) der Schaltungsanordnung (12"') mit zugehöriger Elektrode (8a-n) wärmeleitend verbunden ist.

18. System nach einem der Ansprüche 13-15, **dadurch gekennzeichnet, dass** die Vakuumkammer eine Kammerwand (33) aus Metall, vorzugsweise Aluminium oder Edelstahl, aufweist, die den Innenraum (34) der Vakuumkammer (2) umgibt, wobei die Elektroden (8a-n) in den Innenraum (34) der Vakuumkammer (2) hineinragen und vorzugsweise äquidistant entlang einer Längsrichtung der Vakuumkammer (2) vorgesehen sind und wobei zwischen jedem Schalter (19a-n) und der zugehörigen Elektrode (8an) ein Kondensator (27) zur Unterdrückung eines Gleichspannungsanteils der Hochfrequenz-Ausgangsspannung geschaltet ist.

19. System nach Anspruch 18, **dadurch gekennzeichnet, dass** jeder Schalter (19a-n) der Schaltungsanordnung (12"') mit der metallenen Kammerwand wärmeleitend verbunden ist.

20. System nach einem der Ansprüche 13-19, **dadurch gekennzeichnet, dass** mehrere Schaltungsanordnungen (12, 12', 12", 12"') auf einer Anzahl Platinen (36i) verteilt angeordnet sind, die parallel zueinander geschaltet, vorzugsweise jeweils von einer eigenen Gleichspannungsversorgung (13) gespeist und von einem gemeinsamen Taktgeber (14) mit gemeinsamem Zeittaktsignal versorgt sind, wobei die Leitungsverbindungen derart geführt sind und Zeitverzögerungsglieder enthalten, dass eine möglichst synchrone Zeittaktzuführung zu allen Ansteuereinheiten (17a-n) erhalten wird, und wobei jede Platine (36i) vorzugsweise für sich gegen Überspannung und/oder Überstrom und/oder Übertemperatur geschützt ist.

21. System nach einem der Ansprüche 13-20, **dadurch gekennzeichnet, dass** zwei oder mehrere Ausgangsanschlüsse (24a-d) der Schaltungsanordnung (12), insbesondere über ein Blech (44), miteinander elektrisch leitend verbunden sind, um eine einzige gemeinsame aktive Elektrode (8) für die Plasmakammer (2) zu bilden.

## Claims

1. A circuit assembly for providing high-frequency energy in order to generate an electric discharge in a vacuum chamber, in particular in order to generate plasma, comprising:
a direct voltage supply (13) that provides a direct voltage (U_{cc}) ;
a step-up converter circuit (16) that contains a series circuit consisting of an inductor (18) and a controllable switch (19), wherein the inductor (18) is connected between a pole (21) of the direct voltage supply (13) and a first electrode (D) of the switch (19), wherein a second electrode (S) of the switch (19) is connected to ground, and the switch (19) additionally comprises a control electrode (G);
a control unit (17) that is configured to control the switch (19) with a high-frequency in order to generate high-frequency energy with a periodic pulse-like output voltage (U_{DS}) at the first electrode (D) of the switch (19), a peak value of said output voltage being larger than the value of the direct voltage (U_{cc}) of the direct voltage supply (13), and
an output connection (24) that is intended for direct connection with an electrode (8) of the vacuum chamber (2), without interposition of an impedance matching network and that is connected with the first electrode (D) of the switch (19), to apply the high-frequency energy with the output voltage (U_{DS}) to the vacuum chamber (2).

2. The circuit assembly according to claim 1, **characterized in that** it is free of a resonant circuit made of a coil and a capacitor, or formed by feedback, that is coupled with the switch (19) and/or excited by the switch (19) to generate an HF alternating voltage applied to an output connection, and that it is free of especially adjustable components which serve to match the impedance of the output of the switch (19) to a load to be connected to the output connection (24).

3. The circuit assembly according to claim 1 or 2, **characterized in that** it is designed for operation with low-pressure plasma systems that have a plasma chamber (2) with a working pressure that is less than atmospheric pressure, preferably about 0.01 mbar to 200 mbar, especially preferably about 0.05 mbar to 2 mbar.

4. The circuit assembly according to any one of the preceding claims, **characterized in that** the direct voltage lies in the range from 0 to 400 V, the output voltage (U_{DS}) has peak values that lie in the range from 250 to 900 volts or higher, preferably that are more than 350 volts, and the control frequency and the frequency of the output voltage (U_{DS}) is an ISM frequency (f_{ISM}) that is selected from 6.78 MHz, 13.56 MHz, 27.12 MHz, or 40.68 MHz, preferably is 13.56 MHz.

5. The circuit assembly according to any one of the preceding claims, **characterized in that** the inductor (18) is dimensioned so that when combined with the capacitive component of the impedance of the vacuum chamber (2), which is essentially determined by the structure and geometric arrangement of the vacuum chamber (2), its electrodes (8), the parasitic capacitances to ground of the switch (19) and of a circuit board supporting the circuit assembly (12), it produces a resonant frequency that lies in the range from 0.5 x f_{ISM} to 1.5 x f_{ISM}, preferably in the range from 0.9 x f_{ISM} to 1.4 x f_{ISM}, where f_{ISM} is the frequency of the output voltage (U_{DS}).

6. The circuit assembly according to any one of the preceding claims, **characterized in that** the controllable switch (19) is a power semiconductor switch, especially a bipolar transistor or an electron tube, the switch (19) preferably being a power MOSFET, especially preferably a silicon carbide or gallium nitride power MOSFET.

7. The circuit assembly according to any one of the preceding claims, **characterized in that** the controllable switch (19) has an input capacitance that is less than 5 nF, preferably less than 1 nF, a reverse voltage that is greater than 500 V, preferably greater than 900 V, and rise times and fall times that are less than 15 ns,
wherein the control unit (17) is preferably in the form of an integrated circuit that is configured to control the switch (19) with an actuation current of less than 10 A, preferably less than 5 A.

8. The circuit assembly according to any one of the preceding claims, **characterized in that** a control device (26) is provided to operate the circuit assembly (12), the control device (26) preferably being configured to provide an ignition operation mode in which the output voltage (U_{DS}) generated exceeds that in the normal operation mode by an amount that is preferably at least 10% of the mean of the output voltage in the normal operation mode.

9. The circuit assembly according to claim 8, **characterized in that** the control device (26) is configured to periodically cause the ignition operation mode with a frequency that is significantly lower than the high operating frequency, preferably with a frequency of about 100 Hz, in ongoing operation.

10. The circuit assembly according to any one of the preceding claims, **characterized in that** it comprises two or more step-up converter circuits (16a-n) connected to a common direct voltage supply with associated output connections (24an) to couple high-frequency energy to the vacuum chamber (2), and a number of control units (17a-n) each of which is associated with one or two step-up converter circuits (16a-n).

11. The circuit assembly according to claim 10, **characterized in that** it comprises a clock generator unit (14) which supplies a timing clock signal to all control units (17a-n) that are present so that they are operated synchronously, within a maximum phase shift of 10°, preferably less than 2°.

12. The circuit assembly according to any one of the preceding claims, **characterized in that** it comprises one or more of the following protective devices:
a common protection device for overcurrent shutdown, which is upstream of all switches (19) of the step-up converter circuits (16) and which interrupts the power supply at a definable current consumption of the entire circuit;
an overvoltage protection device that comprises a discharge path (43), which triggers or is triggered in the case of an overvoltage, to eliminate the overvoltage; and/or
a protective device against over-temperature.

13. A system for generating an electric discharge, in particular a low-pressure plasma system, comprising:
a vacuum chamber (2), in particular a plasma chamber, for receiving an ionizable medium, the vacuum chamber (2) having a number of electrodes (8) to couple high-frequency energy into the ionizable medium inductively, capacitively, or directly; and
a circuit assembly (12) for providing high-frequency energy according to any one of the preceding claims, wherein each output connection (24) of the circuit assembly (12) is connected directly, without interposition of an impedance matching network, with an electrode (8) of the vacuum chamber (2) .

14. The system according to claim 13, **characterized in that** the circuit assembly (12) is implemented on a circuit board (36) that is arranged in immediate proximity to the vacuum chamber (2) and is preferably housed in a common housing (11) with the vacuum chamber (2).

15. The system according to claim 13 or 14, **characterized in that** the electrical connection path between the first electrode (D) of each controllable switch (19) of the circuit assembly (12) and the associated electrode (8) of the vacuum chamber (2) is shorter than 100 cm, preferably shorter than 20 cm, especially preferably shorter than 12 cm; and/or
wherein the inductance of the connection path between the first electrode (D) of each controllable switch (19) of the circuit assembly (12) and the associated electrode (8) of the vacuum chamber (2) is less than 10 µH, preferably less than 1 µH, especially preferably less than 250 nH.

16. The system according to any one of the claims 13-15, **characterized in that** the vacuum chamber has a chamber wall (33) made of glass, preferably quartz glass or borosilicate glass, that surrounds the interior (34) of the vacuum chamber (2), the electrodes (8a-n) being arranged on the outer surface of the chamber wall (33) and preferably being provided equidistantly in a longitudinal direction of the vacuum chamber (2).

17. The system according to claim 16, **characterized in that** each switch (19a-n) of the circuit assembly (12"') is thermally conductively connected to the associated electrode (8a-n).

18. The system according to any one of the claims 13-15, **characterized in that** the vacuum chamber has a chamber wall (33) made of metal, preferably aluminum or stainless steel, which surrounds the interior (34) of the vacuum chamber (2), the electrodes (8a-n) projecting into the interior (34) of the vacuum chamber (2) and preferably being provided equidistantly in a longitudinal direction of the vacuum chamber (2), and wherein a capacitor (27) is connected between each switch (19a-n) and the associated electrode (8a-n) to suppress a direct voltage component of the high frequency output voltage.

19. The system according to claim 18, **characterized in that** each switch (19a-n) of the circuit assembly (12"') is thermally conductively connected to the metal chamber wall.

20. The system according to any one of the claims 13-19, **characterized in that** multiple circuit assemblies (12, 12', 12", 12"') are arranged distributed on a number of circuit boards (36i), which are connected to one another in parallel, each of which preferably being fed by its own direct voltage supply (13) and supplied with a common timing clock signal from a common clock generator (14), the lead connections being routed and containing time delay elements so that the most synchronous possible supply of the timing clock to all control units (17a-n) is obtained, and wherein each circuit board (36i) preferably has its own protection against overvoltage and/or overcurrent and/or over-temperature.

21. The system according to any one of the claims 13-20, **characterized in that** two or more output connections (24a-d) of the circuit assembly (12) are electrically conductively connected to one another, in particular through a piece of sheet metal (44), to form a single common active electrode (8) for the plasma chamber (2).

## Revendications

1. Ensemble formant circuit pour fournir une énergie à haute fréquence afin de produire une décharge électrique dans une chambre à vide, en particulier pour produire du plasma,
avec une alimentation en tension continue (13), qui fournit une tension continue (U_{cc}) ;
avec un circuit convertisseur survolteur (16), qui contient un branchement en série composé d'une inductance (18) et d'un commutateur (19) pouvant être piloté, dans lequel l'inductance (18) est raccordée entre un pôle (21) de l'alimentation en tension continue (13) et une première électrode (D) du commutateur (19), dans lequel une deuxième électrode (S) du commutateur (19) est branchée à la masse et dans lequel le commutateur (19) présente en outre une électrode de commande (G) ;
avec une unité de pilotage (17), qui est mise au point pour piloter à haute fréquence le commutateur (19) pour produire une énergie à haute fréquence avec une tension de sortie (U_{DS}) périodique de type impulsion au niveau de la première électrode (D) du commutateur (19), dont la valeur de crête est supérieure à la valeur de la tension continue (U_{CC}) de l'alimentation en tension continue (13), et
avec une borne de sortie (24), qui se destine à être reliée directement à une électrode (8) de la chambre à vide (2) sans intercaler un réseau d'adaptation d'impédance et est reliée à la première électrode (D) du commutateur (19) pour appliquer l'énergie à haute fréquence avec la tension de sortie (U_{DS}) sur la chambre à vide (2) .

2. Ensemble formant circuit selon la revendication 1, **caractérisé en ce qu'**il est sans un circuit résonant formé à partir d'une bobine et d'un condensateur ou par réaction, qui est couplé au commutateur (19) et/ou est excité par le commutateur (19) pour produire une tension alternative HF appliquée sur la borne de sortie, et qu'il est sans composants en particulier pouvant être réglés, qui servent à adapter l'impédance de la sortie du commutateur (19) à une charge à raccorder à la borne de sortie (24).

3. Ensemble formant circuit selon la revendication 1 ou 2, **caractérisé en ce qu'**il est mis au point pour le fonctionnement de systèmes à plasma à basse pression, qui présentent une chambre à plasma (2) avec une pression de fonctionnement, qui est inférieure à la pression atmosphérique, qui de préférence va d'environ 0,01 mbar à 200 mbar, de manière particulièrement préférée d'environ 0,05 à 2 mbar.

4. Ensemble formant circuit selon l'une quelconque des revendications précédentes, **caractérisé en ce que** la tension continue se situe dans la plage de 0 à 400 volts, la tension de sortie (U_{DS}) présente des valeurs de crête, qui se situent dans la plage de 250 à 900 volts ou au-dessus, qui de préférence sont supérieures à 350 volts, et la fréquence de pilotage et la fréquence de la tension de sortie (U_{DS}) sont une fréquence ISM (f_{ISM}), qui est choisie parmi 6,78 MHz, 13,56 MHz, 27,12 MHz et 40,68 MHz, qui de préférence est de 13,56 MHz.

5. Ensemble formant circuit selon l'une quelconque des revendications précédentes, **caractérisé en ce que** l'inductance (18) est dimensionnée de telle manière qu'il découle, en combinaison avec la part capacitive de l'impédance de la chambre à vide (2), qui est définie sensiblement par la structure et l'agencement géométrique de la chambre à vide (2), de ses électrodes (8), par les capacités parasitaires du commutateur (19), et avec une platine supportant l'ensemble formant circuit (12) à la masse, une fréquence de résonance, qui se situe dans la plage de 0,5 x f_{ISM} à 1,5 x f_{ISM}, de préférence dans la plage de 0,9 x f_{ISM} à 1,4 x f_{ISM}, dans lequel f_{ISM} est la fréquence de la tension de sortie (U_{DS}) .

6. Ensemble formant circuit selon l'une quelconque des revendications précédentes, **caractérisé en ce que** le commutateur (19) pouvant être piloté est un commutateur à semi-conducteurs de puissance, en particulier un transistor bipolaire ou un tube électronique, dans lequel le commutateur (19) est de préférence un MOSFET de puissance, de manière particulièrement préférée un MOSFET de puissance à carbure de silicium ou à nitrure de gallium.

7. Ensemble formant circuit selon l'une quelconque des revendications précédentes, **caractérisé en ce que** le commutateur (19) pouvant être piloté présente une capacité d'entrée, qui est inférieure à 5 nF, de préférence inférieure à 1 nF, une tension de blocage, qui est supérieure à 500 V, de préférence supérieure à 900 V, et des temps de hausse et des temps de baisse, qui sont inférieurs à 15 ns,
dans lequel l'unité de pilotage (17) est réalisée de préférence en tant que circuit intégré, qui est mis au point pour piloter le commutateur (19) avec un courant de pilotage inférieur à 10 A, de préférence inférieur à 5 A.

8. Ensemble formant circuit selon l'une quelconque des revendications précédentes, **caractérisé en ce qu'**un dispositif de commande (26) est prévu pour le fonctionnement de l'ensemble formant circuit (12), dans lequel le dispositif de commande (26) est mis au point de préférence pour entraîner un mode de fonctionnement d'allumage, dans lequel la tension de sortie (U_{DS}) produite est par rapport au mode de fonctionnement normal augmentée d'un montant, de préférence d'au moins 10 % de la valeur moyenne de la tension de sortie dans le mode de fonctionnement normal.

9. Ensemble formant circuit selon la revendication 8, **caractérisé en ce que** le dispositif de commande (26) est mis au point pour entraîner le mode de fonctionnement d'allumage de manière périodique, à une fréquence, qui est nettement inférieure à la haute fréquence de fonctionnement, de préférence à une fréquence d'environ 100 Hz, en cours de fonctionnement.

10. Ensemble formant circuit selon l'une quelconque des revendications précédentes, **caractérisé en ce qu'**il présente deux ou plusieurs circuits convertisseurs survolteurs (16a - n) raccordés à une alimentation en tension continue commune avec des bornes de sortie (24a - n) associées pour accoupler l'énergie à haute fréquence à la chambre à vide (2) et un nombre d'unités de pilotage (17a - n), qui sont respectivement associées à un ou deux circuits convertisseurs survolteurs (16a - n).

11. Ensemble formant circuit selon la revendication 10, **caractérisé en ce qu'**il présente une unité d'horloge (14), qui délivre un signal de cadencement à toutes les unités de pilotage (17a - n) présentes de telle manière que celles-ci fonctionnent de manière synchrone, dans un écart de phase de maximum 10°, de préférence inférieur à 2°.

12. Ensemble formant circuit selon l'une quelconque des revendications précédentes, **caractérisé en ce qu'**il présente un ou plusieurs des dispositifs de protection suivants :
un dispositif de protection commun installé en amont de tous les commutateurs (19) des circuits convertisseurs survolteurs (16), pour l'arrêt de courant de surcharge, qui interrompt l'alimentation en courant lors d'une consommation de courant pouvant être constatée de l'ensemble du circuit ;
un dispositif de protection contre la surtension, qui présente une ligne de décharge (43), qui s'allume ou est allumée dans le cas d'une surtension pour supprimer la surtension ; et/ou
un dispositif de protection contre toute surchauffe.

13. Système pour produire une décharge électrique, en particulier système à plasma à basse pression,
avec une chambre à vide (2), en particulier chambre à plasma, pour recevoir un milieu ionisable, dans lequel la chambre à vide (2) présente un nombre d'électrodes (8) pour injecter de l'énergie à haute fréquence de manière inductive, capacitive ou directe dans le milieu ionisable ; et
avec un ensemble formant circuit (12) pour fournir de l'énergie à haute fréquence selon l'une quelconque des revendications précédentes, dans lequel chaque borne de sortie (24) de l'ensemble formant circuit (12) est reliée, directement, sans intercaler un réseau d'adaptation d'impédance, à une électrode (8) de la chambre à vide (2).

14. Système selon la revendication 13, **caractérisé en ce que** l'ensemble formant circuit (12) est implémenté sur une platine (36), qui est disposée à proximité immédiate de la chambre à vide (2) et est logée de préférence avec celle-ci dans un boîtier (11) commun.

15. Système selon la revendication 13 ou 14, **caractérisé en ce que** la longueur de la ligne de liaison électrique entre la première électrode (D) de chaque commutateur (19) pouvant être piloté de l'ensemble formant circuit (12) et l'électrode (8) associée de la chambre à vide (2) est inférieure à 100 cm, de préférence inférieure à 20 cm, de manière particulièrement préférée inférieure à 12 cm ; et/ou
dans lequel l'inductance de la ligne de liaison entre la première électrode (D) de chaque commutateur (19) pouvant être piloté de l'ensemble formant circuit (12) et l'électrode (8) associée de la chambre à vide (2) est inférieure à 10 µH, de préférence inférieure à 1 µH, de manière particulièrement préférée inférieure à 250 nH.

16. Système selon l'une quelconque des revendications 13 à 15, **caractérisé en ce que** la chambre à vide présente une paroi de chambre (33) en verre, de préférence en verre de quartz ou en verre de borosilicate, qui entoure l'espace intérieur (34) de la chambre à vide (2), dans lequel les électrodes (8a - n) sont disposées au niveau du côté extérieur de la paroi de chambre (33) et sont prévues de préférence à équidistance le long d'un sens longitudinal de la chambre à vide (2).

17. Système selon la revendication 16, **caractérisé en ce que** chaque commutateur (19a - n) de l'ensemble formant circuit (12''') est relié de manière thermoconductrice à une électrode (8a - n) associée.

18. Système selon l'une quelconque des revendications 13 à 15, **caractérisé en ce que** la chambre à vide présente une paroi de chambre (33) en métal, de préférence en aluminium ou en acier inoxydable, qui entoure l'espace intérieur (34) de la chambre à vide (2), dans lequel les électrodes (8a - n) dépassent à l'intérieur de l'espace intérieur (34) de la chambre à vide (2) et sont prévues de préférence à équidistance le long d'un sens longitudinal de la chambre à vide (2) et dans lequel un condensateur (27) pour supprimer une part de tension continue de la tension de sortie à haute fréquence est branché entre chaque commutateur (19a - n) et l'électrode (8a - n) associée.

19. Système selon la revendication 18, **caractérisé en ce que** chaque commutateur (19a - n) de l'ensemble formant circuit (12''') est relié de manière thermoconductrice à la paroi de chambre métallique.

20. Système selon l'une quelconque des revendications 13 à 19, **caractérisé en ce que** plusieurs ensembles formant circuits (12, 12', 12'', 12''') sont disposés de manière répartie sur un nombre de platines (36i), qui sont branchées de manière parallèle les unes par rapport aux autres, qui sont de préférence respectivement alimentées par une alimentation en tension continue (13) propre et qui sont alimentées par une horloge (14) commune avec un signal de cadencement commun, dans lequel les liaisons par câble sont guidées et contiennent des organes de temporisation de telle manière qu'une amenée de cadencement synchrone dans la mesure du possible à toutes les unités de pilotage (17a -n) est maintenue, et dans lequel chaque platine (36i) est protégée de préférence en soi contre toute surtension et/ou tout courant de surcharge et/ou toute surchauffe.

21. Système selon l'une quelconque des revendications 13 à 20, **caractérisé en ce que** deux ou plusieurs bornes de sortie (24a - d) de l'ensemble formant circuit (12) sont reliées les unes aux autres de manière électriquement conductrice, en particulier par l'intermédiaire d'une tôle (44), pour former une unique électrode (8) active commune pour la chambre à plasma (2).
